(19) Europäisches Patentamt / European Patent Office / Office européen des brevets

(11) **EP 4 046 268 B1**

(12) **EUROPÄISCHE PATENTSCHRIFT**

(45) Veröffentlichungstag und Bekanntmachung des Hinweises auf die Patenterteilung:
**05.04.2023   Patentblatt 2023/14**

(21) Anmeldenummer: **21703942.9**

(22) Anmeldetag: **12.02.2021**

(51) Internationale Patentklassifikation (IPC):
*H02M 7/537* (2006.01)   *G01R 31/28* (2006.01)
*G01R 31/42* (2006.01)   *H02M 1/12* (2006.01)
*H02M 1/32* (2007.01)

(52) Gemeinsame Patentklassifikation (CPC):
**H02M 1/32; G01R 31/2837; H02M 1/126;**
**H02M 7/537;** G01R 31/42; Y02B 70/10

(86) Internationale Anmeldenummer:
**PCT/EP2021/053437**

(87) Internationale Veröffentlichungsnummer:
**WO 2021/160791 (19.08.2021 Gazette 2021/33)**

(54) **BESTIMMUNG VON FILTERPARAMETERN IN EINEM WECHSELRICHTER**

DETERMINATION OF FILTER PARAMETERS WITHIN AN INVERTER

DÉTERMINATION DES PARAMÈTRES DE FILTRAGE DANS UN ONDULEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.02.2020   EP 20157072**

(43) Veröffentlichungstag der Anmeldung:
**24.08.2022   Patentblatt 2022/34**

(73) Patentinhaber: FRONIUS INTERNATIONAL GmbH
**4643 Pettenbach (AT)**

(72) Erfinder:
• **WIESER, Stefan**
  **4600 Wels-Thalheim (AT)**
• **ROTHBÖCK, Michael**
  **4600 Wels-Thalheim (AT)**
• **PIELER, Roland**
  **4600 Wels-Thalheim (AT)**
• **KREUZER, Harald**
  **4600 Wels-Thalheim (AT)**

(74) Vertreter: **Patentanwälte Pinter & Weiss OG**
**Prinz-Eugen-Straße 70**
**1040 Wien (AT)**

(56) Entgegenhaltungen:
**EP-A1- 3 232 217        EP-B1- 3 069 158**
**WO-A1-2015/071378**

**Beschreibung**

Die Erfindung definiert ein Verfahren zum Regeln einer Schaltanordnung eines Wechselrichters gemäß Anspruch 1, einen hierzu korrespondierenden Wechselrichter gemäß Anspruch 10 und ein die Verfahrensschritte des Verfahrens ausführendes Computerprogramm gemäß Anspruch 11. Vorteilhafte Ausführungsarten der Erfindung sind in den abhängigen Ansprüchen definiert.

Die Schaltanordnung von Wechselrichtern umfasst üblicherweise eine Brückenschaltung, zum Beispiel in der Form eines Vierquadrantenstellers oder ähnlichen Topologien, welche durch das getaktete Schalten der darin enthaltenen Halbleiterschalter auf der Wechselstromseite einen Wechselstrom in den entsprechenden wechselstromführenden Leitungen erzeugt. Die Regelung der Schaltanordnung kann beispielsweise im Sinne einer Pulsbreitenmodulation erfolgen, um eine gute Annäherung an eine gewünschte Wechselstromform (üblicherweise eine Sinusform) zu erreichen.

Da sich durch die Schaltanordnung alleine lediglich Rechteckpulse erzeugen lassen, ist der Schaltanordnung in jeder Phase eine Filterstufe nachgelagert, die über eine Anordnung von Kondensatoren und Drosseln (Induktivitäten) das Wechselstromsignal zur Annäherung an die gewünschte Sinusform glättet.

Die theoretischen Grundlagen für solche Filterstufen sind hinreichend bekannt und stellen bei der Optimierung der Nennwerte dieser Bauteile kein Hindernis dar. Dennoch treten in der Praxis immer wieder Probleme auf. Insbesondere unterscheiden sich die tatsächlichen Kennwerte der Bauteile oft vom bekannten Nennwert und die Kennwerte können sich mit der Zeit durch Alterung oder durch geänderte Umgebungsbedingungen verändern. Beispielsweise kann eine Filterstufe bei einem ein- oder zweiphasigen Wechselrichter aus zumindest einer Induktivität und zumindest einem Kondensator bestehen. Bei dreiphasigen Wechselrichtern sind üblicherweise jeweils mindestens drei Kapazitäten und drei Induktivitäten vorhanden. Die Kennwerte dieser Bauteile haben einen großen Einfluss auf das Regelverhalten und die Schwingungsneigung eines Wechselrichters, weil diese Bauteile Streckenparameter der Regelung sind und damit das Regelverhalten beeinflussen. Der Kondensator hat auch einen Einfluss auf die Regelung der Blindleistung des Wechselrichters. In der Regelung des Wechselrichters sind die Kennwerte dieser Bauteile hinterlegt und beeinflussen die Reglerparameter des implementierten Reglers. Wenn die Regelung nun auf falschen oder ungenauen Kennwerten basiert, können unerwünschte Schwingungen, Stabilitätsprobleme und Abweichungen der Blindleistungen resultieren. Beispielsweise können bei nicht korrekten Kennwerten Oberschwingungen und Verzerrungen des Wechselstromes nicht ausgeregelt werden.

Um die engen Grenzwerte der Blindleistungsabgabe der verschiedenen nationalen Richtlinien einhalten zu können und um den Wechselrichter optimal regeln zu können, sind somit genaue Kenntnisse der Bauteilwerte und somit der Streckenparameter der Filterstufe erforderlich.

Üblicherweise werden die Bauteilwerte bei Fertigung des Wechselrichters vermessen und in der Regelung als Parameter hinterlegt. Diese Arbeitsschritte sind relativ aufwendig und es können auch keine Alterungseffekte oder andere Betriebseinflüsse, welche die Bauteilwerte verändern (z.B. Temperatureinflüsse), abgebildet werden. Um eine vorgegebene Blindleistungsabgabe zu erreichen, kann eine zusätzliche Strommessung am netzseitigen Ausgang des Wechselrichters erfolgen, dies stellt jedoch einen erheblichen Aufwand dar.

Mit derzeitig bekannten Verfahren aus dem Stand der Technik ist es möglich, exakte Bauteilwerte von Kapazitäten und Induktivitäten zu bestimmen. Diese Verfahren sind in der Regel nur für eine bestimmte Topologie geeignet. Darüber hinaus stoßen diese Verfahren bei steigender Anzahl von Bauteilen zudem an ihre Grenzen.

EP 3232217 A1 offenbart ein Verfahren zur Ermittlung aktueller Werte von Filterkapazitäten, wobei bei geladener Filterkapazität über die Halbleiterschalter ein Schwingkreis hergestellt wird, welcher die Filterkapazität(en) umfasst. Die durch die anfangs geladene Filterkapazität angetriebene Schwingung im Schwingkreis wird zur Ermittlung eines aktuellen Wertes dieser Filterkapazität ausgewertet. Die für die Ermittlung benötigten Werte der Filterinduktivitäten werden als unveränderlich und bekannt vorausgesetzt. Die Ermittlung der Filterkapazitäten dient der Überwachung des Zustands der Filterkapazitäten. Insbesondere wird durch Vergleich mit hinterlegten Nennwerten überprüft, ob die Filterkapazitäten noch in Betriebsverfassung sind, oder nicht. Eine Regelung der Schaltanordnung lässt sich damit nicht verbessern.

EP 3069158 B1 offenbart ein Verfahren zum Bestimmen von Kapazitätswerten von Kapazitäten einer Energieversorgungsanlage, wobei ein dreiphasiger Wechselrichter bei getrennten Netzrelais zum Aufbau eines Inselnetzes betrieben wird. Dabei werden mindestens zwei Ausgänge einer Wechselrichterbrücke mit einer gleichphasigen Wechselspannung beaufschlagt. Aus den an den Ausgängen der Wechselrichterbrücke fließenden Strömen und mindestens einer an der Zwischenkreiskapazität und/oder einer Filterkapazität anliegenden Spannung werden aktuelle Kapazitätswerte der Filterkapazitäten und/oder Zwischenkreiskapazitäten ermittelt. Auch hier dient das Bestimmen der Kapazitätswerte der Überprüfung einer Funktion der Filterkapazitäten. Eine Regelung der Schaltanordnung lässt sich damit nicht verbessern.

Die gegenständliche Erfindung hat unter anderem die Aufgabe, ein Verfahren bereitzustellen, mit denen die Regelung der Schaltanordnung eines Wechselrichters mit einer Filterschaltung verbessert werden kann.

Diese und weitere Aufgaben werden gemäß einem ersten Aspekt durch ein Verfahren nach Anspruch 1 und durch einen Wechselrichter mit einer entsprechenden Regelung nach Anspruch 10 gelöst.

Dieses Verfahren erlaubt die Ermittlung von Streckenparametern der Filterschaltung bei einer Vielzahl unterschiedlicher Wechselrichter- und Filterschaltungs-Topologien. Dafür wird eine sich in Summe ergebende Wirkung einer oder mehrerer Kombinationen von miteinander verschalteten Bauteilen ermittelt, ohne eine konkrete Kombination oder einzelne Bauteilwerte kennen zu müssen. Der Stromverlauf kann dabei beispielsweise an einer der Induktivitäten gemessen werden. Die Ermittlung eines Spannungsverlaufs kann vorzugsweise zwischen den beiden am Schwingkreis beteiligten Leitern oder zwischen einem der Leiter gegenüber einem anderen Bezugspotential, z.B. einem Sternmittelpunkt oder einem Zwischenkreismittelpunkt, gemessen werden. Für die Regelung ist die Kenntnis der wirksamen Filterinduktivität und Filterkapazität ausreichend. Damit kann die Regelung an sich ändernde Bauteilwerte in der Filterschaltung nachgeführt werden, sodass ein sich änderndes Regelverhalten des Wechselrichters ausgeglichen werden kann.

In vorteilhafter Weise können die Verfahrensschritte des Aufbringens eines Spannungsimpulses, des Herstellens eines Schwingkreises und des Ermittelns und Auswertens eines Strom- und/oder Spannungsverlaufs an mehreren unterschiedlichen Leiterpaaren wiederholt werden. Dadurch lassen sich insbesondere bei mehrphasigen Wechselrichtern die wirksame Filterinduktivität und Filterkapazität jeder Phase ermittelt werden. Bedarfsweise können in einer solchen Ausführung auch detailliertere Bauteilwerte der der elektrischen Bauteile der Filterschaltung ermittelt werden. Für den Spannungsimpuls kann in einem Zwischenkreiskondensator gespeicherte Energie verwendet werden.

In vorteilhafter Weise wird als Streckenparameter zumindest ein aktueller Wert einer wirksamen Filterkapazität der Filterschaltung und zumindest ein aktueller Wert einer wirksamen Filterinduktivität der Filterschaltung ermittelt. Als "wirksame" Filterkapazität bzw. Filterinduktivität wird dabei im Zusammenhang mit der gegenständlichen Offenbarung entweder ein aktuell einem einzelnen Bauteil einer Filterschaltung entsprechender ermittelter Wert oder ein aktuell einem rechnerischen Bauteil einer Ersatzschaltung der Filterschaltung entsprechender ermittelter Wert bezeichnet, je nachdem ob die jeweilige Filterschaltung die Ermittlung eines Wertes eines tatsächlichen Bauteils ergibt, oder ob lediglich die Werte einer Ersatzschaltung ermittelbar sind. "Wirksame" Filterkapazitäten bzw. Filterinduktivitäten können über mathematische Abhängigkeiten noch weiter miteinander in Beziehung gebracht werden, um sie in einen für eine Regelung brauchbaren wirksamen Wert umzurechnen.

Je nach Topologie des Wechselrichters können unterschiedliche Leiter zur Ermittlung der wirksamen Filterinduktivitäten und wirksamen Filterkapazitäten verwendet werden. Bei einem Wechselrichter mit einem für die Rückführung von der Filteranordnung zur Schaltanordnung vorgesehenen Leiter wird vorteilhaft als erster Leiter einer der anderen Leiter des Wechselrichters verwendet wird und als zweiter Leiter der für die Rückführung von der Filteranordnung zur Schaltanordnung vorgesehene Leiter. Damit können die wirksamen Werte der einzelnen Phasen direkt ermittelt werden. Dabei kann auch ein unerwünschtes Clamping bei der Ermittlung der wirksamen Filterinduktivität und Filterkapazität verhindert werden.

Bei einem Wechselrichter ohne einem für die Rückführung von der Filteranordnung zur Schaltanordnung vorgesehenen Leiter wird vorteilhaft als erster Leiter einer der verfügbaren Leiter des Wechselrichters verwendet und als zweiter Leiter ein anderer der verfügbaren Leiter des Wechselrichters. Das ist grundsätzlich auch bei einem Wechselrichter mit Neutralleiteranschluss möglich. Um dabei ein unerwünschtes Clamping zu verhindern, kann vorgesehen sein, dass ein für die Ermittlung der wirksamen Filterinduktivität und Filterkapazität ungenutzter Leiter des Wechselrichters über die Schaltanordnung auf ein Zwischenkreispotential gelegt wird. Damit kann ein frei schwebendes Potential dieses ungenutzten Leiters, was zum Clamping führen kann, verhindert werden. Das ermöglicht eine genauere Ermittlung der wirksamen Filterinduktivität und Filterkapazität.

Ein zur Rückführung von der Filteranordnung zur Schaltanordnung vorgesehenen Leiter ist ein Leiter, der entweder gar nicht mit dem Netzrelais verbunden ist oder über das Netzrelais mit einem Neutralleiter des Stromnetzes verbunden wird.

In vorteilhafter Weise kann aus dem Strom- und/oder Spannungsverlauf eine Resonanzfrequenz des Schwing-

$$L_m = \frac{1}{2 \cdot \pi \cdot f_{reso}} \cdot \frac{U}{I}$$

kreises ermittelt werden, wobei ein Wert einer wirksamen Filterinduktivität gemäß der Formel ermittelt werden kann.

In vorteilhafte Weise kann aus dem Strom- und/oder Spannungsverlauf eine Resonanzfrequenz des Schwing-

$$C_m = \frac{1}{2 \cdot \pi \cdot f_{reso}} \cdot \frac{I}{U}$$

kreises ermittelt werden, wobei ein Wert einer wirksamen Filterkapazität gemäß der Formel ermittelt wird.

In einer vorteilhaften Ausführung des Verfahrens kann ein Abklingverhalten ermittelt und in der Regelung berücksichtigt werden. Dadurch lässt sich beispielsweise die Güte oder die Dämpfung des Schwingkreises errechnen. Auch der damit verbundene ohmsche Widerstand des Schwingkreises lässt sich daraus bestimmen und kann für die Regelung verwendet werden. Das Abklingverhalten kann beispielsweise bei der Auslegung des Reglers der Regelung, z.B. bei der Ermittlung der Reglerparameter, berücksichtigt werden.

In einer weiteren vorteilhaften Ausführungsform kann die Herstellung eines geschlossenen Schwingkreises unmittelbar nach dem Spannungsimpuls erfolgen. Dadurch kann im Schwingkreis auch bei vollständig entladenen Kondensatoren eine Schwingung erzeugt werden. Als "unmittelbar nach dem Spannungsimpuls" wird im Zusammenhang mit der gegenständlichen Offenbarung eine Zeitdauer bezeichnet, innerhalb derer sich keine relevanten Änderungen der Spannungs- und Stromzustände in den beteiligten Bauteilen ergeben haben. Dies ist insbesondere dann der Fall, wenn sich die entsprechenden Werte zwischen dem Ende des Spannungsimpulses und dem Herstellen des Schwingkreises um weniger als 10 %, bezogen auf deren gesamte Schwankungsbreite, verändert haben.

In einem weiteren Aspekt betrifft die gegenständliche Offenbarung einen entsprechend ausgeführten Wechselrichter, zur Verbindung mit einem Stromnetz über das Netzrelais.

Die gegenständliche Offenbarung betrifft weiters ein Computerprogramm mit Programmcode zur Durchführung der oben beschriebenen Verfahrensschritte, wenn das Computerprogramm auf einer Systemsteuerung eines Wechselrichters ausgeführt wird. Das Computerprogramm kann dabei in vorteilhafter Weise vor dem Durchführen der Verfahrensschritte eine Topologie des Wechselrichters ermitteln. Die Topologie der Schaltanordnung des Wechselrichters kann beispielsweise ausgewählt sein aus H5, HERIC, REFU, FB-DCBP, FB-ZVR, NPC, Conergy-NPC und mit diesen verwandten Topologien. Die derart bezeichneten Topologien sind im Fachbereich bekannt und müssen daher hierin nicht näher erläutert werden.

Der Fachmann ist in der Lage, die hierin offenbarten Lehren auf alle erwähnten Topologien anzuwenden. Dies erlaubt es auch, dasselbe Computerprogramm in einer Vielzahl unterschiedlicher Wechselrichter zu verwenden und erleichtert auch die Fernwartung der Wechselrichter.

Die gegenständliche Erfindung wird nachfolgend unter Bezugnahme auf die Figuren 1 bis 11 näher erläutert, die beispielhaft, schematisch und nicht einschränkend vorteilhafte Ausgestaltungen der Erfindung zeigen. Dabei zeigt

Fig.1 einen Wechselrichter in einer schematischen, generischen Darstellung,

Fig. 2 eine schematische Darstellung einer Schaltung eines Wechselrichters,

Fig. 3 einen Teil einer Schaltung eines Wechselrichters mit einer alternativen Ausführung einer Filterschaltung,

Fig. 4 eine schematische Darstellung einer weiteren Schaltung eines Wechselrichters,

Fig. 5 eine schematische Darstellung einer Schaltung eines Wechselrichters mit vier Leitern, die an die Außenleiter und einen Neutralleiter eines Stromnetztes anschließbar sind,

Fig. 6 eine schematische Darstellung einer Schaltung eines Wechselrichters mit drei Leitern,

Fig. 7 eine weitere schematische Darstellung einer Schaltung eines Wechselrichters mit vier Leitern,

Fig. 8 eine schematische Darstellung einer Ersatzschaltung mit Ersatz-Summenkapazitäten,

Fig.9 eine schematische Darstellung von Spannungsimpuls, Stromverlauf und Spannungsverlauf wie sie sich beispielsweise für das gegenständliche Verfahren ergeben können,

Fig.10 eine Regelung eines Wechselrichters und

Fig.11 eine Ersatzschaltung einer Filterschaltung.

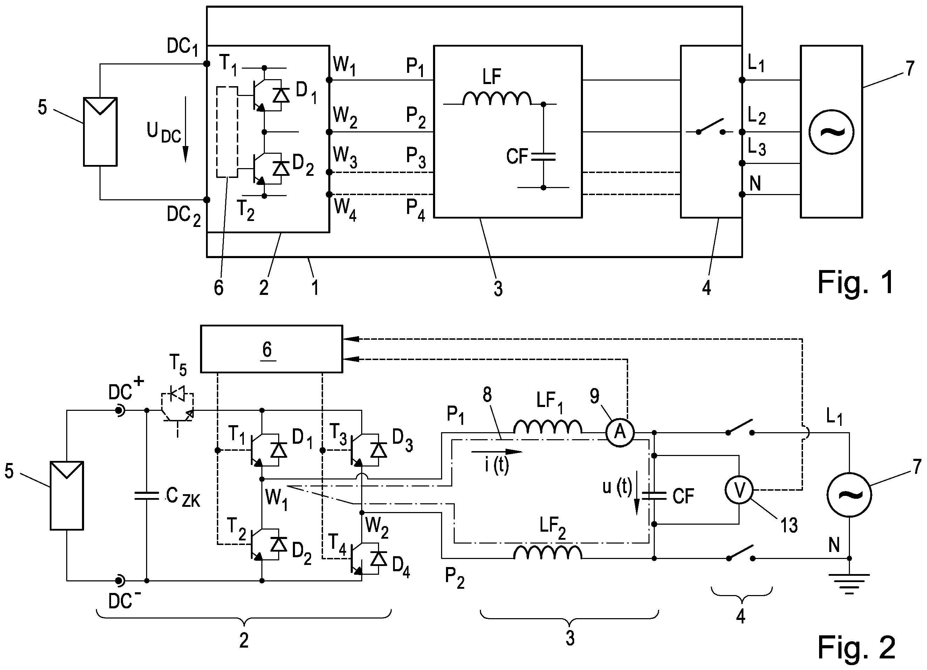

Fig. 1 zeigt einen Wechselrichter 1, der einer Gleichspannung, die von einer Gleichspannungsquelle 5 erzeugt wird, in eine Wechselspannung umwandelt, die in ein Stromnetz 7 (auch als Inselnetz) eingespeist werden kann. Der Wechselrichter 1 der Fig.1 ist dreiphasig mit drei Phasen L1, L2, L3 und mit einem Neutralleiter N ausgeführt.

Die Gleichspannungsquelle 5 erzeugt eine Potenzialdifferenz $U_{DC}$, welche über zwei gleichstromseitige Eingänge DC, und $DC_2$ an eine Schaltanordnung 2 des Wechselrichters 1 angelegt wird. Je nach System können die gleichstromseitigen Eingänge $DC_1$, $DC_2$ direkt von der Gleichspannungsquelle 5 oder von einem vorgelagerten Gleichspannungswandler oder MPP-Tracker stammen. Die Schaltanordnung 2 umfasst in bekannter Weise einen Zwischenkreis, bestehend aus mindestens einem Zwischenkreiskondensator $C_{ZK}$ (nicht eingezeichnet), und mehrere Halbleiterschalter T, die über eine Systemsteuerung 6 gemäß einem Modulationsschema getaktet geschaltet werden. Parallel zu den Halbleiterschaltern T sind üblicherweise Freilaufdioden D angeordnet. Die Halbleiterschalter T sind oftmals in Form von Halbbrückenschaltungen angeordnet, wobei pro Phase zumindest eine Halbbrücke bestehend aus zumindest zwei in Serie geschalteten Halbleitschaltern T vorgesehen ist. Die dadurch erzeugte Wechselspannung kann über einen oder mehrere Leiterausgänge W der Schaltanordnung 2 an entsprechende Leiter P angelegt werden. Pro Phase des Wechselrichters ist zumindest ein Leiter P vorgesehen, wobei auch mehrere Leiterausgänge W zu einer Phase kombiniert werden können (sogenannte verschachtelte (interleaved) Wechselrichtertopologien).

Die Leiter P sind über eine Filterschaltung 3 zu einem Netzrelais 4 geführt, wobei bei geschlossenem Netzrelais 4 die Leiter P des Wechselrichters 1 an die entsprechenden Leiter des Stromnetztes 7 (d.h. zum Beispiel Phasen- bzw. Außenleiter $L_1$, $L_2$, $L_3$ und Neutralleiter N, gegebenenfalls kann auch ein Schutzleiter berücksichtigt sein) angeschlossen sind.

Leiter P, an die über die Schaltanordnung 2 ein Wechselstrom angelegt werden kann, werden im Zusammenhang mit der gegenständlichen Beschreibung auch als "Phasenleiter" bezeichnet. Im Zusammenhang mit der gegenständlichen Offenbarung werden sowohl Phasen- bzw. Außenleiter, als auch Neutralleiter allgemein als "Leiter" bezeichnet. Sofern eine Unterscheidung von Phasenleiter und Neutralleiter sinnvoll oder erforderlich ist, wird dieses im Text explizit angeführt, sofern es sich nicht logisch und zwingend aus dem Zusammenhang ergibt.

Die Filterschaltung 3 umfasst im Allgemeinen zumindest eine Filterinduktivität LF (Drossel), die in einem Leiter P direkt anschließend an den entsprechenden Leiterausgang W angeordnet ist, und zumindest eine Filterkapazität CF, die, vorzugsweise "hinter" der Filterinduktivität LF (d.h. zwischen der Filterinduktivität LF und dem Netzrelais 4), zwei Leiter P miteinander verbindet. Gegebenenfalls kann die Verbindung bei mehrphasigen Topologien über einen Sternmittelpunkt und eine weitere Filterkapazität CF erfolgen.

Im Zusammenhang mit der gegenständlichen Offenbarung werden Bauteile und Elemente, die in ähnlicher oder identischer Form in einer Zeichnung mehrfach vorkommen, mit einer das Element identifizierenden Großbuchstabenkombination (z.B. gleichstromseitiger Eingang DC, Halbleiterschalter T, Leiterausgang W, Leiter P, Filterinduktivität LF, Filterkapazität CF, etc.) gekennzeichnet und jeweils durch tiefergestellte Indizes nummeriert. Diese Differenzierung dient lediglich der besseren Unterscheidbarkeit und ist nicht einschränkend auszulegen.

Je nach Ausführungsform des Wechselrichters 1 kann dieser mit zwei, drei oder vier Leitern P ausgestattet sein. Wechselrichter mit zwei Leitern $P_1$, $P_2$ können beispielsweise an zwei Phasen $L_1$, $L_2$ des Stromnetzes 7 oder an eine Phase L und den Neutralleiter N angeschlossen werden. Wechselrichter 1 mit drei Leitern $P_1$, $P_2$, $P_3$ können beispielsweise an die drei Phasen $L_1$, $L_2$, $L_3$ eines Dreiphasen-Stromnetzes 7 angeschlossen werden. Wechselrichter 1 mit vier Leitern $P_1$, $P_2$, $P_3$, $P_4$ können beispielsweise an die die drei Phasen $L_1$, $L_2$, $L_3$ eines Dreiphasen-Stromnetzes 7 und an dessen Neutralleiter N angeschlossen werden.

Die gegenständliche Offenbarung ist nicht auf eine bestimmte Topologie des Wechselrichters 1, insbesondere der Schaltanordnung 2 und der Filterschaltung 3, eingeschränkt. Vielmehr lassen sich die hierin offenbarten Lehren auf eine Vielzahl unterschiedlicher Topologien anwenden, sofern bestimmte Voraussetzungen erfüllt sind, die im Folgenden unter Bezugnahme auf einige detaillierter ausgeführte konkrete Schaltungen beispielhaft erläutert werden.

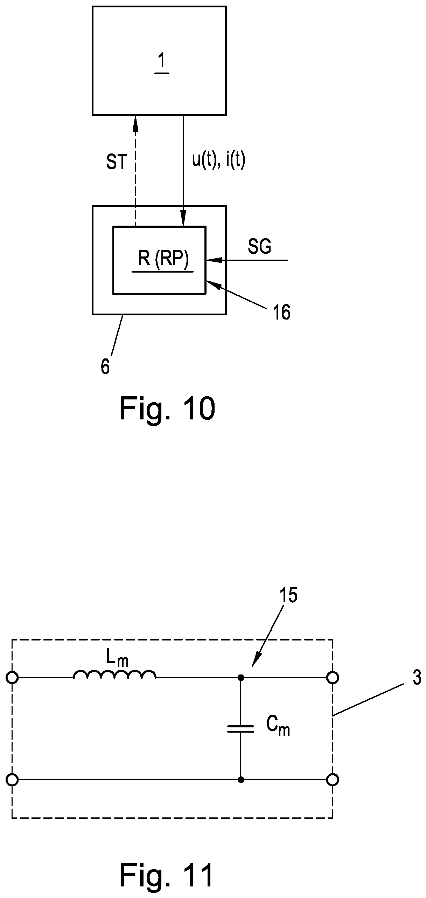

Der Wechselrichter 1, konkret die Schaltanordnung 2 des Wechselrichters 1, wird von einer Regelung 16 geregelt, wie in Fig.10 vereinfacht dargestellt. Die Regelung 16 ist in einer Systemsteuerung 6, vorzugsweise eine mikroprozessorbasierte Hardware, implementiert, vorzugsweise als Software. Die Systemsteuerung 6 mit der Regelung 16 kann aber auch als integrierter Schaltkreis, beispielsweise als Anwendungsspezifische integrierte Schaltung (ASIC) oder Field Programmable Gate Array (FPGA), oder auch als analoge Schaltung ausgeführt sein.

Für die Regelung 16 ist ein Regler R(RP) mit Reglerparameter RP vorgesehen, wobei die Reglerparameter RP an die Streckenparameter SP der zu regelnden Regelstrecke angepasst werden, um das gewünschte Regelverhalten zu erzielen. Die Filterschaltung 3 beeinflusst die Regelung 16 des Wechselrichters 1, sodass die davon abgeleiteten Streckenparameter SP in der Regelung 16, konkret im Regler R, berücksichtigt werden, beispielsweise in Form eines Reglerparameters RP oder in dem die Streckenparameter SP den Wert eines Reglerparameter RP beeinflussen. Neben den Streckenparametern SP, die aus der Filterschaltung 3 abgeleitet werden, können natürlich noch weitere Streckenparameter in der Regelung 16 berücksichtigt werden. Die Auslegung eines Reglers R mit einem vorgegebenen Regelgesetz (z.B. PI-Regler, PID-Regler usw.) anhand der die Reglerparameter RP und deren Abhängigkeit von den Streckenparametern SP festgelegt werden, ist dem Fachmann hinlänglich bekannt, sodass darauf nicht weiter eingegangen werden muss. Zur Regelung des Wechselrichters 1, konkret der Schaltanordnung 2 bzw. der Halbleiterschalter T der Schaltanordnung 2, ermittelt der Regler R in Abhängigkeit von einer vorgegebenen Sollgröße SG, beispielsweise ein gewünschter Strom pro Phase oder eine gewünschte Spannung pro Phase, Stellgrößen ST für die Schaltanordnung 2, beispielsweise Schaltbefehle für die Halbleiterschalter T oder ein Tastgrad einer Pulsweitenmodulation (PWM) Regelung, die dann in Schaltbefehle umgewandelt wird.

Zur Regelung des Wechselrichters 1, wird für die Filterschaltung 3 für jede Phase des Wechselrichters 1 eine Ersatzschaltung aus einer wirksamen Filterinduktivität $L_m$, die sich aus der zumindest einen Filterinduktivität LF der Phase der Filterschaltung 3 und der Topologie der Filterschaltung 3 ergibt, und einer wirksamen Filterkapazität $C_m$, die sich aus der zumindest einen Filterkapazität CF der Phase der Filterschaltung 3 und der Topologie der Filterschaltung 3 ergibt, verwendet (Fig.11). Die wirksame Filterkapazität $C_m$ und die wirksame Filterinduktivität $L_m$ sind Streckenparameter SP für die Regelung 16 der Schaltanordnung 2 und werden aus Messwerten eines elektrischen Stroms i(t) und einer elektrischen Spannung u(t) wie unten beschrieben, beispielsweise in der Systemsteuerung 6, ermittelt.

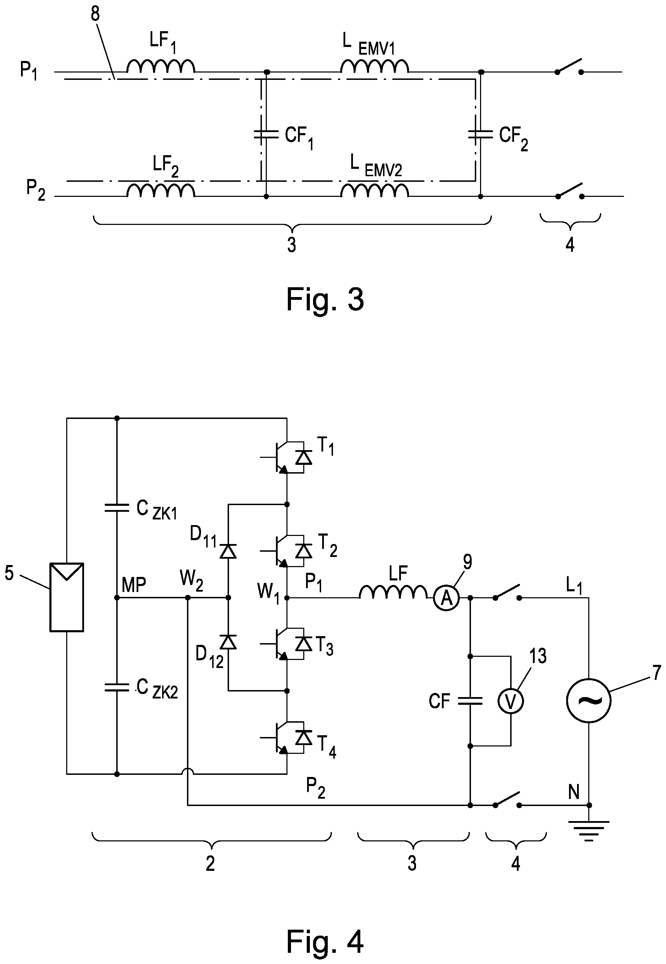

Die Fig. 2 und 4 zeigen beispielhaft Wechselrichter 1 zur Verbindung mit einem Außenleiter L1 und einem Neutralleiter N, bei denen Streckenparameter wie die wirksame Filterkapazität $C_m$ und die wirksame Filterinduktivität $L_m$ ermittelt werden.

Fig. 2 zeigt eine Ausführungsform eines Wechselrichters 1 mit einer herkömmlichen H-Brückenschaltung, bei der über vier Halbleiterschalter $T_1$-$T_4$ die Potenzialdifferenz $U_{DC}$ zwischen einem hohen Potential (positiver Pol DC$^+$) und einem niedrigem Potential (negativer Pol DC$^-$) auf unterschiedliche Weise an die beiden Leiterausgänge $W_1$ und $W_2$ angelegt werden kann. An den Leiterausgang $W_1$ ist in dieser Ausführungsform eine Phase L1 und an den Leiterausgang $W_2$ ist der Neutralleiter N des Stromnetzes 7 angeschlossen. Im Betrieb werden die Halbleiterschalter T über eine Systemsteuerung 6 gemäß einem Modulationsschema angesteuert, wobei vier Schaltzustände genutzt werden können:

- positiver Stromfluss: $T_1$ und $T_4$ geschlossen, $T_3$ und $T_2$ offen

- negativer Stromfluss: $T_2$ und $T_3$ geschlossen, $T_1$ und $T_4$ offen

- Nullvolt über DC$^+$: $T_1$ und $T_3$ geschlossen, $T_2$ und $T_4$ offen

- Nullvolt über DC$^-$: $T_2$ und $T_4$ geschlossen, $T_1$ und $T_3$ offen

Entsprechende Modulationsschemata sind im Fachbereich hinlänglich bekannt und es ist daher nicht erforderlich, diese hierin näher zu beschreiben.

Unabhängig von der Topologie erzeugt die Schaltung der Halbleiterschalter T gemäß einem Modulationsschema an den Leiterausgängen W jeweils einen rechteckig verlaufenden Wechselstrom, der vor dem Einspeisen in das Stromnetz 7 in eine möglichst gleichmäßig verlaufende Sinuswelle umgewandelt werden muss. Dies wird von der Filterschaltung 3 und den darin vorgesehenen Filterinduktivitäten $LF_1$, $LF_2$ und der Filterkapazität CF gewährleistet. Durch die konkrete Filtertopologie der Filterschaltung 3 und die Kennwerte der im Filter vorhandenen Filterkapazitäten CF und Filterinduktivitäten LF wird der Filterschaltung 3 ein bestimmtes Filterverhalten verliehen, das durch die Bauteilwerte beschrieben werden kann. Die Werte sind abhängig von der jeweiligen Frequenz, wobei für die Regelung der Schaltanordnung 2 nicht nur das Verhalten bei der Frequenz des Wechselstroms (typisch z.B. 16,7Hz, 50Hz, 60Hz), sondern gegebenenfalls auch bei Störfrequenzen und/oder bei Frequenzen, die für Rundsteuersignale des Netzbetreibers verwendet werden, berücksichtigt werden können. Im Betrieb des Wechselrichters 1 fließen Blindströme über die Filterkapazität CF, die durch die Regelung in der Systemsteuerung 6 geregelt werden sollen. Somit beeinflussen die Filterkapazität CF und die Filterinduktivitäten LF1, LF2 die Regelung des Wechselrichters 1.

Zur Erhöhung der Genauigkeit des auszuregelnden Wertes der Blindleistung und/oder zur Optimierung der Regelung 16 der Systemsteuerung 6 ist es daher wesentlich, die Kennwerte der Streckenparameter SP für die Regelung der Schaltanordnung 2 möglichst genau zu kennen. Diese Streckenparameter SP, bzw. die Bauteile der Filterschaltung 3, die in den Streckenparametern SP für die Regelung zusammengefasst sind, sind jedoch alterungsbedingten Veränderungen oder Änderungen der Umgebungseinflüsse unterworfen.

Je nach Topologie der Filterschaltung 3 sind die einzelnen Bauteilwerte der Filterkapazität(en) CF und der Filterinduktivität(en) LF nur aufwendig zu ermitteln. Für die erfindungsgemäße Regelung 16 wird daher pro Phase eine Ersatzschaltung 15 der Filterschaltung 3 mit einer wirksamen Filterkapazität $C_m$ und einer wirksamen Filterinduktivität $L_m$ verwendet, wie beispielhaft in Fig.11 dargestellt. In der Ersatzschaltung 15 für eine Phase des Wechselrichters 1 sind alle Filterinduktivitäten LF der Phase in der wirksamen Filterinduktivität $L_m$ zusammengefasst oder vernachlässigt ($L_{emv}$). Gleichermaßen sind alle Filterkapazitäten CF der Phase in der wirksamen Filterkapazität $C_m$ zusammengefasst. Es ist offensichtlich, dass die Art und Weise wie diese Zusammenfassung zu erfolgen hat, von der Topologie der Filterschaltung 3 abhängt. Ein Fachmann auf diesem Gebiet ist aber jedenfalls in der Lage aus einer konkreten Filterschaltung 3 die wirksame Filterkapazität $C_m$ und die wirksame Filterinduktivität $L_m$ der Ersatzschaltung 15 zu ermitteln. Die Regelung 16, konkret die Reglerparameter RP des Reglers R der Regelung 16, wird anhand der Ersatzschaltung 15 ausgelegt.

Im Folgenden wird unter Bezugnahme auf die in Fig. 2 dargestellte Schaltung ein Verfahren beschrieben, mit dem die aktuellen Streckenparameter SP der Filterschaltung 3 des Wechselrichters 1 schnell, einfach und genau ermittelt werden können. Optimaler Weise kann das Verfahren unmittelbar bevor der Wechselrichter 1 durch Schließen der Netzrelais 4 an das Stromnetz 7 angeschlossen wird durchgeführt werden. Damit können die Streckenparameter SP beispielsweise regelmäßig oder bedarfsweise vor dem Schließen des Netzrelais 4 oder auch nach dem Öffnen des Netzrelais 4 durchgeführt werden, womit immer aktuelle Streckenparameter SP ermittelt und in der Regelung berücksichtigt werden können. Eine Veränderung der Streckenparameter SP kann daher laufend in der Regelung berücksichtigt werden.

Das Verfahren wird bei geöffneten Netzrelais 4 durchgeführt, d.h. der Wechselrichter 1 ist vom Stromnetz 7, bzw. dessen Außenleiter $L_1$, $L_2$, $L_3$ und Neutralleiter N, getrennt und alle Halbleiterschalter T sind offen. Durch kurzes Schließen des ersten und des vierten Halbleiterschalters $T_1$ und $T_4$, beispielsweise für einen Zeitraum von einigen wenigen Mikrosekunden (z.B. 5 Mikrosekunden) wird an die Leiterausgänge $W_1$ und $W_2$ ein Spannungsimpuls angelegt, indem für diesen Zeitraum eine Zwischenkreisspannung anliegt. Alternativ kann der Spannungsimpuls auch in umgekehrter Polarität durch Schließen des zweiten und des dritten Halbleiterschalters $T_2$, und $T_3$ erzeugt werden. Unmittelbar danach wird in der Schaltanordnung 2 eine Verbindung der Leiterausgänge $W_1$ und $W_2$ hergestellt, sodass ein Schwingkreis 8 hergestellt wird, der ausgehend von ersten Leiterausgang $W_1$ über die erste Leitung $P_1$, die erste Filterinduktivität $LF_1$, die Filterkapazität CF, die zweite Leitung $P_2$, die zweite Filterinduktivität $LF_2$ zum zweiten Leiterausgang $W_2$ verläuft, und durch die Verbindung zwischen $W_1$ und $W_2$ geschlossen wird. Der Schwingkreis 8 ist in Fig. 2 durch eine Strich-Punkt-Linie angedeutet. Die Verbindung zwischen $W_1$ und $W_2$ kann bei der dargestellten Topologie entweder durch Schließen der "oberen" Halbleiterschalter $T_1$ und $T_3$ oder durch Schließen der "unteren" Halbleiterschalter $T_2$ und $T_4$ erfolgen. In vielen Topologien ist es jedoch auch möglich, die Leiterausgänge W miteinander zu verbinden, ohne dass an diesen eine Potentialdifferenz anliegt. Gegebenenfalls können zu diesem Zweck weitere Halbleiterschalter vorgesehen sein, wie etwa der in Strichlinien dargestellte Halbleiterschalter $T_5$, mit dem die Brückenschaltung vom positiven Pol $DC^+$ getrennt werden kann.

Wenn die Filterkapazität CF vor Anlegen des Spannungsimpulses geladen ist, können Probleme mit Überstrom, etwa wenn der Kondensator zu hoch aufgeladen ist, mit einer vorteilhaften Ausführungsform des Verfahrens verhindert werden. Ein Überstrom kann grundsätzlich mit einem ausreichend kurzen Spannungsimpuls, und zusätzlich mit entsprechend gewählter Polarität, vermieden werden. In einer weiteren Ausführungsform des Verfahrens wird die Filterkapazität CF vor dem Anlegen des Spannungsimpulses entladen, um einen Überstrom auszuschließen und eine wiederkehrende Ermittlung der Streckenparameter unter vergleichbaren Bedingungen durchführen zu können.

Auch bei einer zu Beginn vollständig entladenen Filterkapazität CF bildet sich unmittelbar nach dem Spannungsimpuls im Schwingkreis 8 eine freie Schwingung aus, die als Stromverlauf i(t) (z.B. Strommessung 9 an der ersten oder zweiten Filterinduktivität LF1, LF2) und Spannungsverlauf u(t) (Spannungsmessung 13 über die Filterkapazität CF) ermittelt werden kann. Die Frequenz des Stromverlaufs (und Spannungsverlaufs) entspricht der Resonanzfrequenz $f_{reso}$ des Schwingkreises 8. Aus dem Stromverlauf i(t) und dem Spannungsverlaufs u(t) lassen sich somit die Resonanzfrequenz $f_{reso}$, die Spannungsamplitude U und die Stromamplitude I ermitteln. Aus diesen Werten lässt sich für die Filterschaltung 3 eine wirksame Filterinduktivität $L_m$ und eine wirksame Filterkapazität $C_m$ ermitteln.

Anhand des auf den Schwingkreis 8 mit der Ersatzschaltung 15 der Filterschaltung 3 angewendeten Energieerhaltungssatzes

$$L_m \cdot I^2 = C_m \cdot U^2 \qquad \text{(Glg. 1)}$$

und der Herz'schen Schwingungsgleichung

$$f_{reso} = \frac{1}{2\pi \sqrt{L_m \cdot C_m}} \qquad \text{(Glg. 2)}$$

ergibt sich für die wirksame Filterinduktivität

$$L_m = \frac{1}{2 \cdot \pi \cdot f_{reso}} \cdot \frac{U}{I} \qquad \text{(Glg. 3)}$$

und die wirksame Filterkapazität

$$C_m = \frac{1}{2 \cdot \pi \cdot f_{reso}} \cdot \frac{I}{U} \qquad \text{(Glg. 4).}$$

Die wirksame Filterinduktivität $L_m$ und wirksame Filterkapazität $C_m$ können sich durch einen einzigen oder mehrere physische Bauteile einer Filterschaltung 3 ergeben.

In der in Fig. 2 dargestellten einfachen Filterschaltung 3 entspricht die ermittelte wirksame Filterkapazität $C_m$ dem aktuellen Wert der Filterkapazität CF. Die wirksame Filterinduktivität $L_m$ entspricht der Summe der beiden Filterinduktivitäten $LF_1$ und $LF_2$.

Durch Ermittlung des Abklingverhaltens der freien Schwingung kann die Güte bzw. die Dämpfung des Schwingkreises 8 errechnet werden. Auch der damit verbundene ohmsche Widerstand lässt sich daraus bestimmen. Güte, bzw. Dämpfung des Schwingkreises 8 und ohmscher Widerstand können in der Folge als weitere Parameter für die Regelung des Wechselrichters 1 zur Erzeugung von Wechselstrom und Wechselspannung bzw. zur Regelungsoptimierung herangezogen werden.

Es ist offensichtlich, dass es für die Bestimmung der wirksamen Filterkapazität $C_m$ und der wirksamen Filterinduktivität $L_m$ in einem Wechselrichter 1 wie in Fig.2 unbeachtlich ist, ob dieser an einen Phasenleiter $L_1$ und einen Neutralleiter N (wie in Fig.2) angeschlossen ist, oder an zwei Phasenleitern $L_1$, $L_2$. Bei offenem Netzrelais 4 gibt es nur die Leiter P des Wechselrichters 1, die für die Ausbildung eines Schwingkreises 8 verwendet werden. Ebenso ist dafür die konkrete Ausführung der Schaltanordnung 2 nicht entscheidend.

Wie dies unter Bezugnahme auf Fig. 3 erläutert wird, kann das obige Verfahren auch bei komplexeren Filterschaltungen 3 angewendet werden. Die Filterschaltung 3 umfasst im ersten Leiter $P_1$ eine Filterinduktivität $LF_1$ und als zweite Induktivität eine EMV-Drossel $L_{EMV1}$ zur Dämpfung von Hochfrequenzstörungen. Auch der zweite Leiter $P_2$ umfasst neben der zweiten Filterinduktivität $LF_2$ eine EMV-Drossel $L_{EMV2}$. Anstelle einer einzigen Filterkapazität CF sind in der Filterschaltung 3 zwei parallele Filterkapazitäten $CF_1$ und $CF_2$ angeordnet, wobei die beiden EMV-Drosseln $L_{EMV}$ zwischen der ersten $CF_1$ und zweite Filterkapazität $CF_2$ angeordnet sind. Die restliche, in Fig. 3 nicht dargestellte Schaltung des Wechselrichters 1 kann beispielsweise der Fig. 2 entsprechen.

Der Schwingkreis 8 der Fig. 3 teilt sich somit zwischen den beiden Filterinduktivitäten $LF_1$ und $LF_2$ in zwei parallele Zweige auf, wobei der erste Zweig die erste Filterkapazität $CF_1$ umfasst und der zweite Zweig in Reihe die erste EMV-Drossel $L_{EMV1}$, die zweite Filterkapazität $CF_2$ und die zweite EMV-Drossel $L_{EMV2}$ umfasst.

Hinsichtlich des oben beschriebenen Verfahrens zur Ermittlung der Streckenparameter SP können die EMV-Drosseln $L_{EMV}$ bei der Berechnung vernachlässigt werden. Da EMV-Drosseln üblicherweise für eine deutlich höhere Frequenz ausgelegt sind, als die Filterinduktivitäten LF, und vergleichsweise sehr klein sind, ergeben sich daraus keine Nachteile. Auf das Schwingverhalten des Schwingkreises 8 haben die EMV-Drosseln einen vernachlässigbaren Einfluss. Somit kann die wirksame Filterinduktivität $L_m$ für die Ersatzschaltung 15 auf analoge Weise ermittelt werden wie beim oben beschriebenen Verfahren und sie entspricht wiederum der Summe der beiden Filterinduktivitäten $LF_1$ und $LF_2$. Auch die wirksame Filterkapazität $C_m$ kann auf analoge Weise ermittelt werden und sie entspricht in diesem Fall der Summe der beiden parallelen Filterkapazitäten $CF_1$ und $CF_2$.

Für die Regelung 16 der Schaltanordnung 2 ist eine Kenntnis der wirksamen Filterkapazität $C_m$ und wirksame Filterinduktivität $L_m$ ausreichend, sodass der zusätzliche Aufwand für eine Ermittlung der einzelnen Werte der parallelen Filterkapazitäten $CF_1$ und $CF_2$ und der beiden Filterinduktivitäten $LF_1$ und $LF_2$ nicht erforderlich ist und entfallen kann.

Fig. 4 zeigt ein weiteres Beispiel in Form eines Mehrstufen (multi-level) Wechselrichters 1, wobei die Schaltanordnung 2 in dem Fall einer sogenannten "NPC-Topologie" entspricht. "NPC" steht in dem Fall für "Neutral Point Clamped", das heißt dass ein Leiterausgang W der Schaltanordnung 2, im dargestellten Fall der zweite Leiterausgang $W_2$, an den der zweite Leiter $P_2$ angeschlossen ist, auf den Zwischenkreismittelpunkt MP zwischen zwei Zwischenkreiskondensatoren $C_{ZK1}$, $C_{ZK2}$ gelegt ist. Der zweite Leiter $P_2$ ist mit der Filterschaltung 3 verbunden und in diesem Ausführungsbeispiel bei geschlossenem Netzrelais 4 an den Neutralleiter N des Stromnetzes 7 angeschlossen. Am Leiterausgang $W_1$ der Schaltanordnung, an der der erste Leiter $P_1$ angeschlossen ist, können aufgrund der Topologie der Schaltanordnung 2 nun mehr als zwei Spannungsstufen (DC+, DC-) eingestellt werden. In der Ausgestaltung nach Fig.4 kann nun auch über die inneren Halbleiterschalter $T_2$, $T_3$ und die Clampdioden $D_{11}$, $D_{12}$ auch die Spannungsstufe 0 eingestellt werden. Die vier Halbleiterschalter $T_1$ bis $T_4$ der NPC-Halbleiterbrücke lassen sich insbesondere in den folgenden Zuständen schalten:

- positiver Stromfluss: $T_1$ und $T_2$ geschlossen, $T_3$ und $T_4$ offen

- negativer Stromfluss: $T_3$ und $T_4$ geschlossen, $T_1$ und $T_2$ offen

- Freilauf (Nullvolt) über die beiden Freilaufdioden: $T_2$ und $T_3$ geschlossen, $T_1$ und $T_4$ offen

Zur Ermittlung der Streckenparameter SP wird wiederum bei geöffneten Netzrelais 4 ein Spannungsimpuls an einen Leiterausgang $W_1$, $W_2$ angelegt (zum Beispiel durch Schließen der beiden "oberen" Halbleiterschalter $T_1$ und $T_2$ oder der beiden unteren Halbleiterschalter $T_3$ und $T_4$), indem eine Zwischenkreisspannung anliegt und unmittelbar danach wird durch Öffnen der beiden äußeren Halbleiterschalter $T_1$, $T_4$ und Schließen der beiden mittleren Halbleiterschalter $T_2$ und $T_3$ der erste Leiterausgang $W_1$ über eine der beiden Clampdioden $D_{11}$, $D_{12}$ mit dem zweiten Leiterausgang $W_2$ verbunden und ein Schwingkreis 8 hergestellt.

Die Ermittlung der Streckenparameter SP erfolgt wiederum gemäß dem oben beschriebenen Verfahren, wobei in diesem Fall lediglich eine Filterinduktivität LF und eine Filterkapazität CF zu berücksichtigen sind. Somit können die Werte der einzelnen Filterkomponenten direkt ermittelt werden. Die von der Regelung zu berücksichtigende wirksame

Filterkapazität $C_m$ entspricht dem aktuellen Wert der Filterkapazität CF und die wirksame Filterinduktivität $L_m$ entspricht dem aktuellen Wert der Filterinduktivität LF. Üblicherweise sind jedoch komplexere Topologien der Filterschaltung 3 vorgesehen, sodass eine derartige einfache Zuordnung unüblich ist und nur der Erläuterung dient.

Mithilfe der im Zusammenhang mit der Beschreibung der Fig. 2 bis 4 für ein- bzw. zweiphasige Wechselrichter beispielhaft offenbarten Lehren kann die gegenständliche Offenbarung auch auf zahlreiche andere ein-, zwei- oder dreiphasige Wechselrichter angewendet werden, die eine unterschiedliche Topologie aufweisen. Zu Beispielen solcher Topologien zählen, ohne darauf beschränkt zu sein, die unter der Bezeichnung H5, HERIC, REFU, FB-DCBP, FB-ZVR, NPC, Conergy-NPC bekannten, sowie damit verwandte bzw. ähnliche Topologien.

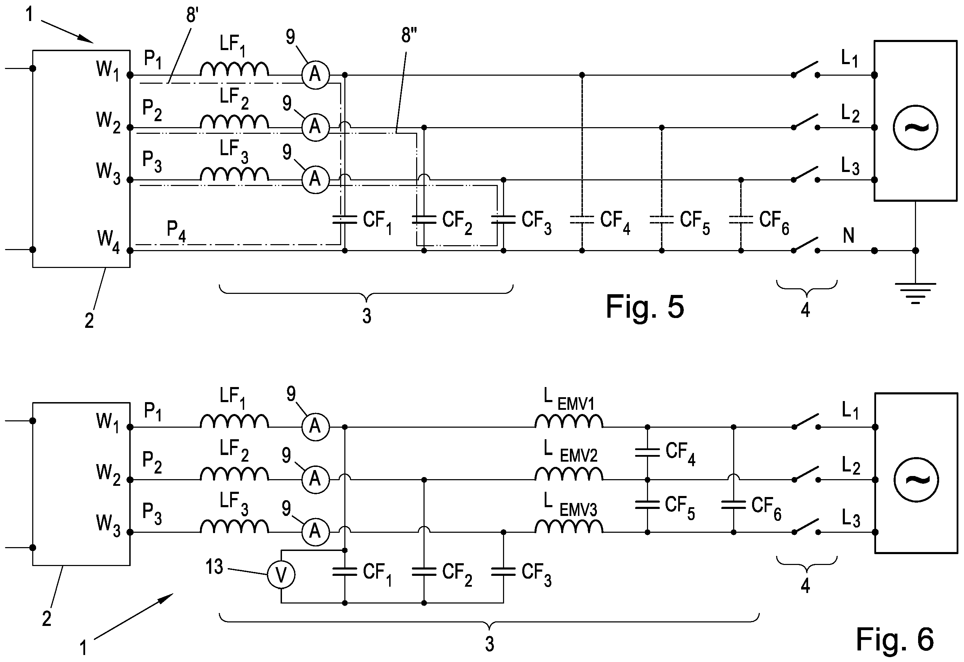

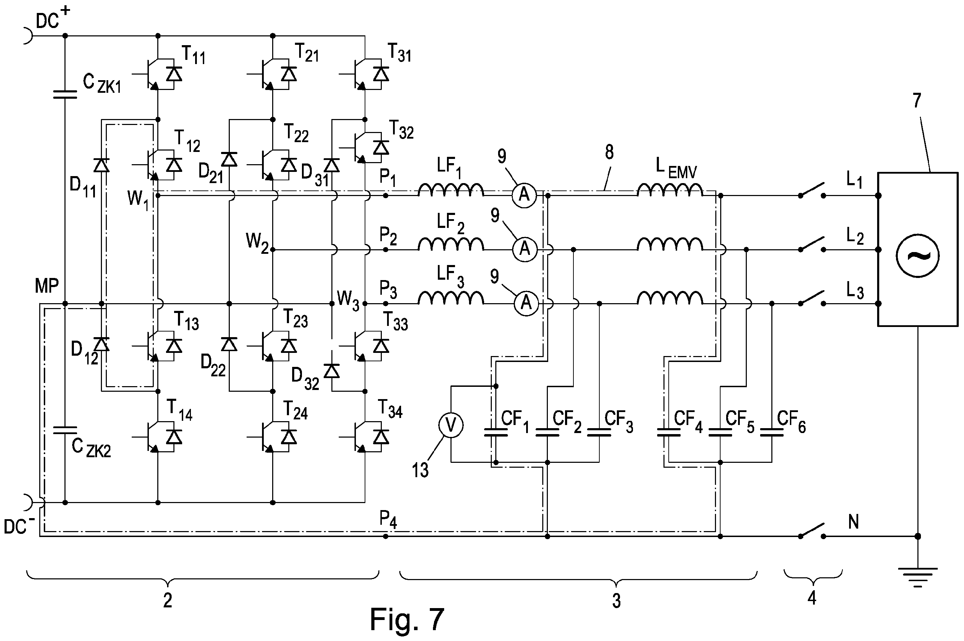

Die gegenständlichen Lehren lassen sich vorteilhaft auf dreiphasige Wechselrichter 1 mit einer Rückführung der Filterschaltung 3 in die Schaltanordnung 2 mittels eines Leiters $P_4$ anwenden, wie im Folgenden unter Bezugnahme auf die Fig. 5 und 7 beispielhaft erläutert wird. Der für die Rückführung verwendete Leiter $P_4$ kann bei geschlossenem Netzrelais 4 auch an den Neutralleiter N des Stromnetzes 7 angeschlossen sein. Ein wesentlicher Vorteil liegt darin, dass das Ermittlungsverfahren der Streckenparameter SP unabhängig von der Anzahl der Kapazitäten anwendbar ist.

Dreiphasige Wechselrichter 1 können beispielsweise durch Kombinieren dreier einphasiger Wechselrichter hergestellt werden. Andererseits können auch spezifische Schaltungen für Wechselrichter mit drei Phasen (mit oder ohne Rückführung) verwendet werden. Der Aufbau und die Topologie von ein-, zwei und dreiphasigen Wechselrichtern ist dem Fachmann an sich bekannt. Die Topologien, die in Zusammenhang mit den oben genannten Wechselrichtern 1 angeführt und beschrieben sind, können durch eine entsprechende Erweiterung der Schaltung auch für dreiphasige Systeme verwendet werden. Grundsätzlich ist die gegenständliche Offenbarung nicht auf bestimmte Topologien eingeschränkt, sofern nicht konkrete technische Gründe (etwa eine inkompatible Topologie) einer Umsetzung der hierin offenbarten Lehren entgegenstehen.

Fig. 5 zeigt einen Wechselrichter 1 mit einer Schaltanordnung 2 mit vier Leiterausgängen $W_1$-$W_4$, wobei die entsprechenden ersten drei Leiter $P_1$-$P_3$ über das Netzrelais 4 an die Außenleiter $L_1$-$L_3$ des Stromnetzes 7 angeschlossen sind, und wobei der vierte Leiter $P_4$ an den Neutralleiter N angeschlossen ist (was aber nicht zwingend erforderlich ist). In den ersten drei Leitern $P_1$-$P_3$ ist jeweils direkt anschließend an den entsprechenden Leiterausgang W eine Filterinduktivität $LF_1$-$LF_3$ vorgesehen und dahinter ist jeweils eine Filterkapazität $CF_1$-$CF_3$ zwischen dem entsprechenden Leiter $P_1$-$P_3$ (Phasenleiter) und dem vierten Leiter $P_4$ (der der Rückführung der Filterschaltung 3 zur Schaltanordnung 2 dient und bei geschlossenem Netzrelais 4 an den Neutralleiter N angeschlossen ist) angeordnet, die damit in einer Sternanordnung angeordnet sind. Die Phasenleiter $P_1$-$P_3$ können von der Schaltanordnung 2 jeweils mit einer (insbesondere pulsbreitenmodulierten) Wechselspannung beaufschlagt werden. Der vierte Leiter $P_4$ zur Rückführung kann in der Schaltanordnung 2 auf einen Zwischenkreismittelpunkt MP zwischen zwei Zwischenkreiskapazitäten $C_{ZK1}$, $C_{ZK2}$ gelegt sein (vergleichbar mit der Verbindung P2 in Fig.4).

Das oben im Zusammenhang mit ein- bzw. zweiphasigen Wechselrichtern 1 offenbarte Verfahren zur Ermittlung von Streckenparametern eignet sich grundsätzlich für Wechselrichter 1, die zwischen jeweils zwei Ausgängen der Schaltbrücke über eine Filterschaltung 3 einen Schwingkreis 8 herstellen können und kann z.B. auf die Filtertopologie der Fig. 5 angewendet werden.

Für die Ermittlung der Streckenparameter SP wird zuerst einer der ersten drei Leiterausgänge $W_1$-$W_3$ mit einem Spannungsimpuls beaufschlagt. Unmittelbar nach dem Spannungsimpuls wird, ausgehend von diesem Leiterausgang ein Schwingkreis 8' über den zugeordneten Leiter P, über die Filterschaltung 3 und den für die Rückführung vorgesehenen und am Leiterausgang $W_4$ angeschlossenen Leiter $P_4$ aufgebaut. Der Schwingkreis 8' kann über die entsprechende Filterinduktivität LF, die entsprechende Filterkapazität CF und den für die Rückführung vorgesehenen vierten Leiter $P_4$ geführt werden, indem der entsprechende Leiterausgang $W_1$-$W_3$ über die Schaltanordnung 2 mit dem vierten Leiterausgang $W_4$ verbunden wird. Ein solcher Schwingkreis 8' ist in Fig. 5 durch die Strich-Punkt-Linie zwischen dem Leiterausgang $W_1$ und dem Leiterausgang $W_4$ dargestellt. Das Verfahren wird in diesem Sinne auch für die übrigen Leiterausgänge $W_1$-$W_3$ angewandt. Auf diese Weise erhält man die wirksame Filterkapazität $C_m$ und wirksame Filterinduktivität $L_m$ jeder Phase des Wechselrichters 1 wie oben beschrieben.

Fig. 7 zeigt eine weitere Ausführungsform eines dreiphasigen Wechselrichters 1 mit einem für die Rückführung von der Filterschaltung 3 zur Schaltanordnung 2 vorgesehenen Leiter $P_4$, wobei die Schaltanordnung 2 einer 3L-NPC-Topologie (Three Level Neutral Point Clamped) entspricht. Von den vier Leitern $P_1$-$P_4$ sind bei geschlossenem Netzrelais 4 die drei ersten Leiter $P_1$-$P_3$ jeweils einer Phase $L_1$-$L_3$ des Stromnetzes 7 zugeordnet (Phasenleiter), der vierte Leiter $P_4$ ist dem Neutralleiter N zugeordnet und an einen Zwischenkreismittelpunkt MP des Zwischenkreises angeschlossen. Diese Verbindung des Leiters $P_4$ zu einem Neutralleiter N bei geschlossenem Netzrelais 4 ist aber nicht zwingend vorhanden.

Die Filterschaltung 3 umfasst pro Leiter $P_1$, $P_2$, $P_3$ jeweils eine Filterinduktivität $LF_1$-$LF_3$. Weiters ist in jedem Leiter $P_1$, $P_2$, $P_3$ eine EMV-Drossel $L_{EMV}$ vorgesehen, wobei die EMV-Drosseln $L_{EMV}$ für die Ermittlung der Streckenparameter SP wiederum wie bereits erklärt vernachlässigt werden können. Zwischen den Filterinduktivitäten $LF_1$-$LF_3$ und den EMV-Drosseln $L_{EMV}$ ist eine erste Sternschaltung mit drei Filterkapazitäten $CF_1$-$CF_3$ angeordnet und nach den EMV-Drosseln $L_{EMV}$ ist eine zweite Sternschaltung mit drei weiteren Filterkapazitäten $CF_4$-$CF_6$ angeordnet. Die Stern-

mittelpunkte der beiden Sternschaltungen sind jeweils mit dem für die Rückführung zur Schaltanordnung 2 vorgesehenen vierten Leiter $P_4$ verbunden.

Mit der dargestellten Schaltanordnung 2 lässt sich auf jeden der drei Leiter L (d.h. die drei ersten Leiter $P_1$-$P_3$), also für jede Phase des Wechselrichters 1, entweder ein positives Potential (positiver Pol $DC^+$), ein negatives Potential (negativer Pol $DC^-$) oder das dazwischenliegende neutrale Potential des Zwischenkreismittelpunkts MP des Zwischenkreises in Form eines Spannungsimpulses anlegen (die entsprechende Schaltung der Halbleiterschalter T korrespondiert mit der im Zusammenhang mit Fig. 4 beschriebenen Vorgehensweise). Somit lässt sich für jede Phase des Wechselrichters 1 ein Schwingkreis 8 herstellen, der ausgehend vom Mittelpunkt MP über die beiden Clampdioden $D_{x1}$, $D_{x2}$ und die beiden mittleren Halbleiterschalter $T_{x2}$, $T_{x3}$ der jeweiligen Phase, den Leiterausgang W der jeweiligen Phase, die Filterinduktivität LF und die beiden parallelen Filterkapazitäten CF der jeweiligen Phase und den vierten Leiter P4 zur Rückführung zurück zum Zwischenkreismittelpunkt MP verläuft.

Als Spannungsimpuls kann entweder ein positiver Spannungsimpuls (Halbleiterschalter $T_{x1}$ und $T_{x2}$ geschlossen) oder ein negativer Spannungsimpuls (Halbleiterschalter $T_{x3}$ und $T_{x4}$ geschlossen) aufgebracht werden. Danach wird wiederum der Schwingkreis 8 wie oben beschrieben hergestellt und der Strom- und/oder Spannungsverlauf gemessen und ausgewertet. Dieser Vorgang wird für jede der drei Phasen durchgeführt. Dadurch können als Streckenparameter SP insbesondere wieder die Werte der wirksamen Filterinduktivität $L_m$ und der wirksamen Filterkapazität $C_m$ für jede Phase ermittelt werden.

In Fig. 7 ist der Schwingkreis 8 für die erste Phase, d.h. über den Leiter $P_1$, durch eine Strich-Punkt-Linie dargestellt. Die Auswertung des Verhaltens dieses Schwingkreises 8 erlaubt die Ermittlung des Wertes der wirksamen Filterinduktivität $L_m$ in Form der ersten Filterinduktivität LF1 und der wirksamen Filterkapazität $C_m$, die in dem Fall der Summe der beiden parallelen Filterkapazitäten $CF_1$ und $CF_4$ dieses Schwingkreises 8 entspricht und als eine Summenkapazität ermittelt wird. Die wirksamen Filterinduktivitäten $L_m$ und wirksamen Filterkapazitäten $C_m$ der anderen beiden Phasen werden analog ermittelt. Aufgrund der Verbindung des Kondensator-Sternpunktes der Filterkondensatoren CF mit dem Zwischenkreismittelpunkt MP können die wirksamen Filterinduktivitäten $L_m$ und wirksamen Filterkapazitäten $C_m$ der einzelnen Phasen auf einfache Weise mit einem Schwingkreis 8 zwischen einem der Leiterausgänge $W_1$, $W_2$, $W_3$ der Leiter $P_1$, $P_2$, $P_3$ und dem Leiterausgang $W_4$ des für die Rückführung vorgesehenen Leiters $P_4$ gebildet werden.

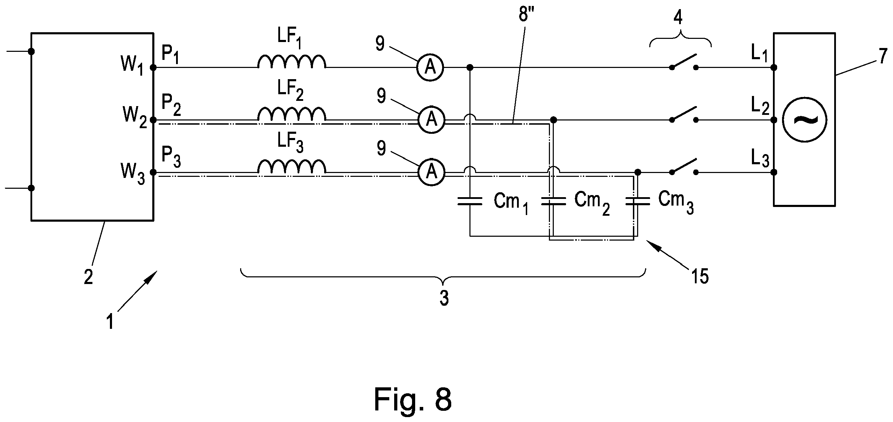

Andererseits können auch zwei "Phasenausgänge" (d.h. zwei der ersten drei Leiterausgänge $W_1$-$W_3$) jeweils über die Schaltanordnung 2 miteinander verbunden werden. Das ist sowohl für die Beispiele in Fig. 5 und Fig. 7 möglich aber besonders ist dies für das Beispiel in Fig. 6 und Fig.8 geeignet, da hier keine Rückführung der Filterschaltung 3 zur Schaltanordnung 2 vorhanden ist. Der entsprechende Schwingkreis 8" ist etwas komplexer und in Fig. 5 und Fig. 6 durch eine Strich-Punkt-Punkt-Linie zwischen den Leiterausgängen $W_2$ und $W_3$ beispielhaft dargestellt. Dieser beispielhafte Schwingkreis 8" umfasst in Fig. 5 in einer Reihenschaltung die zweite Filterinduktivität $LF_2$, die zweite Filterkapazität $CF_2$, die dritte Filterkapazität $CF_3$ und die dritte Filterinduktivität $LF_3$.

Somit stehen in einer Ausführung nach Fig. 5 oder Fig.7 sechs unterschiedliche Schwingkreise 8', 8" zur Verfügung (während etwa in dem untenstehend beschriebenen Fall der in Fig. 6 dargestellten Schaltung drei unterschiedliche Schwingkreise 8" zur Verfügung stehen). In dem in Fig. 5 dargestellten einfachen Fall (Schaltkreis 8') ist auch eine Ermittlung der exakten Parameter aller Filterkapazitäten CF und Filterinduktivitäten LF anhand einer Auswertung der drei über den für die Rückführung vorgesehenen Leiter $L_4$ (d.h. den vierten Leiterausgang $W_4$) geführten Schwingkreise 8' exakt möglich. Für die Schaltung der Fig. 6 etwa, lassen sich mit den hierin offenbarten Verfahren keine auf einzelne Filterkapazitäten bezogene Parameter bestimmen, wohl aber die effektiv wirksame Filterinduktivität $L_m$ und wirksame Filterkapazität $C_m$, was für die Regelung 16 des Wechselrichters 1 ausreichend ist. Die jeweils bevorzugte Variante des Verfahrens hängt somit von der konkreten Topologie der Schaltanordnung 2 bzw. der damit verbundenen Filterschaltung 3 ab.

Falls weitere Filterkapazitäten CF in der Filterschaltung 3 vorhanden sind (wie dies beispielsweise in Fig. 5 durch die strichliert eingezeichneten Filterkapazitäten $CF_4$ bis $CF_6$ angedeutet ist), kann wiederum als wirksame Filterkapazität $C_m$ der Summenwert paralleler Filterkapazitäten im Schwingkreis ermittelt werden.

Fig. 6 zeigt einen dreiphasigen Wechselrichter 1, der jedoch eine Filterschaltung 3 aufweist, die keine Rückführung zur Schaltanordnung 2. Drei Leiterausgänge $W_1$-$W_3$ sind jeweils an einen Leiter $P_1$-$P_3$ angeschlossen, wobei die Leiter jeweils auf eine Phase $L_1$-$L_3$ des Stromnetzes 7 aufschaltbar sind.

Die Filterschaltung 3 umfasst (in Richtung von den Leiterausgängen W zu den Netzrelais 4) drei Filterinduktivitäten $LF_1$-$LF_3$ (eine pro Leiter), eine Sternschaltung mit drei Filterkapazitäten $CF_1$-$CF_3$ und einem freien Sternpunkt, drei EMV-Drosseln $L_{EMV1}$-$L_{EMV3}$ (eine pro Leiter) und drei Filterkapazitäten $CF_4$-$CF_6$ in Dreiecksschaltung. Der freie Sternpunkt könnte bei geschlossenem Netzrelais 4 auch an einen Neutralleiter N des Stromnetzes 7 angeschlossen sein.

Jede Kombination aus Stern- und/oder Dreieckschaltungen von Kondensatoren lässt sich als Ersatzschaltung in Form einer reinen Sternschaltung oder in Form einer reinen Dreieckschaltung darstellen. In diesem Sinne kann für die Stern-Dreieckschaltung in Fig. 6 die Dreieckschaltung aus $CF_4$, $CF_5$, $CF_6$, gedanklich beispielsweise durch eine äquivalente Sternschaltung ersetzt werden. Dadurch ergeben sich mit der Sternschaltung aus $CF_1$, $CF_2$, $CF_3$ zwei Sternschaltungen, welche wiederum auf eine einzige äquivalente Sternschaltung zusammengefasst werden können.

So ergibt sich für Fig. 6 eine Ersatzschaltung 15 mit den wirksamen Filterkapazitäten $C_{m1}$, $C_{m2}$, $C_{m3}$, als Ersatz-Summenkapazitäten, gemäß Fig. 8.

Für die Ermittlung der Streckenparameter SP in Fig. 6 wird wiederum zuerst einer der drei Leiterausgänge $W_1$-$W_3$ mit einem Spannungsimpuls beaufschlagt. Unmittelbar nach dem Spannungsimpuls wird, ausgehend von diesem Leiterausgang ein Schwingkreis 8" über die Filterschaltung 3 aufgebaut, wobei dieser Leiterausgang über die Schaltanordnung 2 mit einem der zwei verbliebenen Leiterausgänge $W_1$-$W_3$ kurzgeschlossen wird. Der entsprechende Schwingkreis 8" verläuft dabei wie zuvor der Spannungsimpuls parallel über die Sternschaltung und die Dreiecksschaltung der Filterschaltung 3, wobei die EMV-Drosseln $L_{EMV}$ wiederum vernachlässigt werden. Rechnerisch werden die wirksamen Filterkapazitäten $C_{m1}$, $C_{m2}$, $C_{m3}$ der Ersatzschaltung 15 in Fig. 6 mit der Ermittlung der Ersatz-Summenkapazitäten in der Fig. 8 erhalten.

Wird eine Sternschaltung als Ersatzschaltung 15 wie in Fig. 8 für Fig. 6 herangezogen, lassen sich über das oben beschriebene Verfahren drei Summenkapazitäten $C_{m12}$, $C_{m23}$, $C_{m31}$ ermitteln. Diese entsprechen bei einer Stern-Ersatzschaltung den Summenkapazitäten der Serienschaltung aus jeweils zwei Ersatz-Summenkapazitäten ($C_{m1}$, $C_{m2}$, $C_{m3}$). Mit den ermittelten Summenkapazitäten $C_{m12}$, $C_{m23}$, $C_{m31}$ lässt sich folgendes Gleichungssystem aufstellen:

$$C_{m12} = \frac{C_{m1} * C_{m2}}{C_{m1} + C_{m2}}$$

$$C_{m23} = \frac{C_{m2} * C_{m3}}{C_{m2} + C_{m3}}$$

$$C_{m31} = \frac{C_{m1} * C_{m3}}{C_{m1} + C_{m3}}$$

Aus diesem Gleichungssystem können die wirksamen Filterkapazitäten $C_{m1}$, $C_{m2}$, $C_{m3}$ der einzelnen Phasen ermittelt werden, indem das obige Gleichungssystem nach den wirksamen Filterkapazitäten $C_{m1}$, $C_{m2}$, $C_{m3}$ aufgelöst wird, was zu den folgenden Gleichungen führt:

$$C_{m1} = \frac{2 * C_{m12} * C_{m23} * C_{m31}}{C_{m12} * C_{m23} - C_{m12} * C_{m31} + C_{m23} * C_{m31}}$$

$$C_{m2} = -\frac{2 * C_{m12} * C_{m23} * C_{m31}}{C_{m12} * C_{m23} - C_{m12} * C_{m31} - C_{m23} * C_{m31}}$$

$$C_{m3} = \frac{2 * C_{m12} * C_{m23} * C_{m31}}{C_{m12} * C_{m23} + C_{m12} * C_{m31} - C_{m23} * C_{m31}}$$

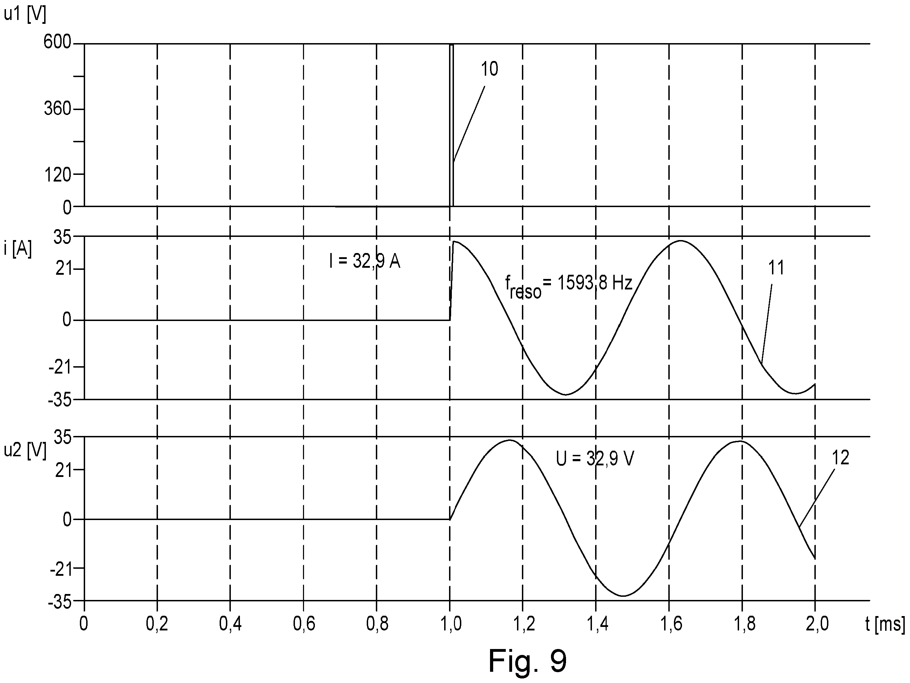

Zur Veranschaulichung zeigt Fig. 9 in einem ersten Diagrammverlauf einen Spannungsimpuls 10 und in zwei weiteren Diagrammen ist die Reaktion des Schwingkreises 8", etwa gemäß Fig. 8, auf den Spannungsimpuls 10 dargestellt. Der Schwingkreis 8" besteht im dargestellten Beispiel aus den wirksamen Filterkapazitäten $C_{m2}$, $C_{m3}$ und den Filterinduktivitäten $LF_2$, $LF_3$ (die in diesem Beispiel den wirksamen Filterinduktivitäten $L_m$ entsprechen). Über den ermittelten Stromverlauf 11 bzw. den Spannungsverlauf 12 lässt sich unter anderen eine Resonanzfrequenz ($f_{reso}$= 1593,8Hz), eine Stromamplitude (I = 32,9A) sowie eine Spannungsamplitude (U = 32,9V) bestimmen. In Glg. 4 eingesetzt ergibt sich für die wirksame Summenkapazität $C_{m23}$ ein Wert von $C_{m23}$= 100µF. In gleicher Weise lässt sich mit dem Verfahren $C_{m12}$ und $C_{m31}$ ermitteln. Damit lassen sich mit dem obigen Gleichungssystem die wirksamen Filterkapazitäten $C_{m1}$, $C_{m2}$, $C_{m3}$ ermitteln.

Die wirksamen Filterkapazitäten $C_{m1}$, $C_{m2}$, $C_{m3}$ entsprechen den für die Regelung benötigten aktuellen Werten und können wiederum bei Bedarf mittels Stern-Dreiecktransformation in wirksame Filterkapazitäten für eine Dreieck-Ersatzschaltung von Kondensatoren transformiert werden, falls eine Regelung 16 die wirksamen Filterkapazitäten $C_{m1}$, $C_{m2}$, $C_{m3}$ in dieser Form benötigt.

Über das oben beschriebene Verfahren lassen sich gemäß Fig. 8 ebenfalls drei Summeninduktivitäten $L_{m12}$, $L_{m23}$, $L_{m31}$ ermitteln. Mit diesen lässt sich folgendes Gleichungssystem aufstellen:

$$L_{m12} = LF_1 + LF_2$$

$$L_{m23} = LF_3 + LF_2$$

$$L_{m31} = LF_1 + LF_3$$

Analog zur Ermittlung der Summenkapazität $C_{m23}$ lässt sich die Summeninduktivität $L_{m23}$ mittels Glg.3 und den gemäß Fig. 9 ermittelten Werten mit $L_{m23}$ = 100μH berechnen. In gleicher Weise lassen sich mit dem Verfahren die Summeninduktivitäten $L_{m12}$ und $L_{m31}$ ermitteln. Damit lässt sich das obige Gleichungssystem nach den wirksamen Filterinduktivitäten $L_{m1}$=LF1, $L_{m2}$=$LF_2$ und $L_{m3}$=$LF_3$ auflösen und die aktuellen Werte berechnen:

$$L_{m1} = \frac{1}{2}(L_{m12} - L_{m23} + L_{m31})$$

$$L_{m2} = \frac{1}{2}(L_{m12} + L_{m23} - L_{m31})$$

$$L_{m3} = \frac{1}{2}(-L_{m12} + L_{m23} + L_{m31})$$

Der beispielhafte Spannungsimpuls 10 in Fig. 9 wird durch die Schaltanordnung 2 eines Wechselrichters 1 zum Zeitpunkt t = 1ms mit u1 = 600V erzeugt. Im davorliegenden Ruhezustand (z.B. vor einem gewöhnlichen Betrieb) sind in diesem Beispiel der bzw. die vom Spannungsimpuls 10 betroffenen Filterkondensatoren entladen (u2 = 0V) und durch die betroffen Filterinduktivität(en) fließt kein Strom (i = 0A). Der Stromverlauf 11 zeigt den Stromfluss durch die wirksame Filterinduktivität $L_m$. Bei maximalem Strom ist die über die wirksame Filterkapazität $C_m$ gemessene Spannung gemäß Spannungsverlauf 12 minimal bzw. null und die gesamte Energie des Schwingkreises 8 ist im Magnetfeld der wirksamen Filterinduktivität $C_m$ gespeichert. Der Schwingkreis 8 wird unmittelbar nach dem Impuls ausgebildet. Kurz vor t = 1,2ms ist der Stromfluss 11 durch die wirksame Filterinduktivität $L_m$ minimal bzw. null und die gesamte Energie des Schwingkreises 8 ist in der wirksamen Filterkapazität $C_m$ gespeichert, wobei der Spannungsverlauf 12 die maximale Spannung aufweist. Glg.1 basiert auf diesem Zusammenhang.

Basierend auf den Gleichungssystemen können also die aktuellen Werte für die wirksame Filterkapazität $C_m$ und die aktuellen Werte für die wirksame Filterinduktivität $L_m$ ermittelt werden.

Bei Wechselrichtern 1 mit drei oder mehr Phasenleitern $P_1$, $P_2$, $P_3$ und ohne definierten Nullzustand, wie beispielsweise eine Topologie wie in Fig.6, können sich aber gewisse Schwierigkeiten bei der Bestimmung der wirksamen Filterkapazitäten $C_m$ und der wirksamen Filterinduktivitäten $L_m$ der einzelnen Phasen ergeben. Im in Fig.6 dargestellten Testfall wird die Schwingspannung an den Filterkapazitäten $CF_2$, $CF_3$ aufgeteilt. Im Idealfall sind beide Filterkapazitäten $CF_2$, $CF_3$ gleich groß, wodurch sich am gemeinsamen Kondensator-Sternpunkt das Potential einstellt, welches von der Schaltanordnung 2 für den Spannungsimpuls angelegt wurde (z.B. DC+ oder DC-). Sind die beiden Filterkapazitäten $CF_2$, $CF_3$ aber nicht gleich groß, was in der Realität durchaus möglich ist, so gilt das nicht mehr. In diesem Fall schwingt das Potential des Kondensator-Sternpunktes. Diese Schwingung des Potentials des Kondensator-Sternpunktes lässt über die Filterinduktivität $LF_1$ auch das Potential am Leiterausgang $W_1$ schwingen, weil $W_1$ für diesen Testfall als offen anzusehen ist. Diese unerwünschte Schwingung des Leiterausganges $W_1$ kann dazu führen, dass das Potential der positiven Zwischenkreisspannung DC+ überschritten wird, oder dass das Potential der negativen Zwischenkreisspannung DC- unterschritten wird. In beiden Fällen würde eine der Freilaufdioden D der Halbleiterschalter T im Schaltzweig des Leiterausganges $W_1$ leitend werden, wodurch ein Strom in den Zwischenkreis fließt und die Messung von Strom und Spannung verfälscht, was zu einer ungenauen Bestimmung der wirksamen Filterkapazitäten $C_m$ und der wirksamen Filterinduktivitäten $L_m$ führt. Dieser Effekt wird als "Clamping" bezeichnet. Dieser Clamping Effekt ist unabhängig davon, ob die Filterkondensatoren $CF_1$, $CF_2$, $CF_3$ in Stern- oder Dreiecksschaltung angeordnet sind und kann auch bei unterschiedlich großen Filterinduktivitäten $LF_1$, $LF_2$, $LF_3$ auftreten. Es ist offensichtlich, dass dieses Clamping auch bei anderen gebildeten Schwingkreisen 8" als im Testfall der Fig.6 dargestellt gleichermaßen auftreten kann. Durch eine Strommessung des Stromes über die Filterinduktivtäten LF (die für das erfindungsgemäße Verfahren ohnehin implementiert sein wird) kann ein derartiges Clamping erkannt und bedarfsweise für die Regelung berücksichtigt werden.

Um ein solches Clamping zu verhindern, kann eine Topologie mit einem als Rückführung der Filterschaltung 3 zur Schaltanordnung 2 verwendeten Leiter $P_4$, der auf einen definierten Nullzustand verbunden ist, verwendet werden. Eine solche Topologie wäre beispielsweise eine Topologie wie in Fig.7 dargestellt, wo der Leiter $P_4$ auf den Zwischenkreismittelpunkt MP gelegt ist, oder wie in Fig.5, wenn der Leiter $P_4$ ebenso auf einen Zwischenkreismittelpunkt MP gelegt ist. Damit kann ein schwingendes Potential am Kondensator-Sternpunkt verhindert werden.

Eine andere Möglichkeit zur Verhinderung des Clampings wäre, das Potential der für den jeweiligen Testfall ungenutzten Phase (im Testfall der Fig.6 die Phase $P_1$) nicht freischwebend zu lassen, sondern über die Schaltanordnung auf jenes Potential zu legen, das für den Spannungsimpuls verwendet wurde (also DC+ oder DC-), wodurch die Schwingung des Potentials am zugehörigen Leiterausgang W verhindert wird. Durch diese Beschaltung sind aber die Filterinduktivität $LF_1$ und Filterkapazitäten $CF_1$ der für den Testfall ungenutzten Phase $P_1$ am Schwingkreis 8" des Testfalls beteiligt und müssen damit bei der Ermittlung der wirksamen Filterkapazitäten $C_m$ und wirksamen Filterinduktivitäten $L_m$ berücksichtigt werden. Die oben erläuterten Gleichungen würden dadurch etwas komplexer werden, an der grundlegenden Vorgehensweise zur Ermittlung der wirksamen Filterkapazitäten $C_m$ und wirksamen Filterinduktivitäten $L_m$ würde das aber nichts ändern.

Das Abklingverhalten des Schwingkreises ist in Fig. 9 nicht dargestellt, davon ausgehend sind jedoch die Parameter dazu ebenfalls ermittelbar und können in der Regelung ebenso berücksichtigt werden. Aufgrund des Abklingverhaltens ist es für die Genauigkeit der ermittelten Streckenparameter SP von Bedeutung, Spannungs- und Stromamplitude U, I des Spannungs- und Stromverlaufes 11, 12 zeitlich möglichst nahe beieinanderliegend zu ermitteln, sodass ein Energiegleichgewicht gemäß Glg.1 angenommen werden kann. Die Zeitspanne ist von der Resonanzfrequenz und dem Abklingverhalten abhängig und beträgt z.B. eine oder einige wenige Periodendauern der Resonanzfrequenz. Das in Fig. 9 dargestellte Verfahren kann auch auf alle übrigen zuvor offenbarten und auch auf andere Topologien übertragen werden.

Zum Zweck der Regelung 16 der Energieumwandlung bzw. der Schaltanordnung 2 des Wechselrichters 1 sind Streckenparameter SP in Form von wirksamen Filterkapazitäten $C_m$ und/oder wirksamen Filterinduktivitäten $L_m$ einer Filterschaltung 3 ausreichend. Eine Bestimmung einzelner Bauteilwerte ist nicht erforderlich, kann sich jedoch in bestimmten Fällen ergeben. Für Werte von wirksamen Filterkapazitäten $C_m$ kann auch ein erlaubter Wertebereich definiert werden, wobei für Werte außerhalb des erlaubten Wertebereichs Fehlermeldungen oder Fehlerzustände eines Wechselrichter 1 definiert werden können.

**Patentansprüche**

1. Verfahren zum Regeln einer Schaltanordnung (2) eines Wechselrichters (1) mit einer Regelung (16), wobei der Wechselrichter (1) die Schaltanordnung (2), eine Filterschaltung (3) und ein Netzrelais (4) aufweist und die Regelung (16) Streckenparameter der Filterschaltung (3) des Wechselrichters (1) berücksichtigt, wobei die Schaltanordnung (2) zumindest zwei Leiterausgänge ($W_1$, $W_2$, $W_3$, $W_4$) aufweist und jeder Leiterausgang ($W_1$, $W_2$, $W_3$, $W_4$) mit einem Leiter ($P_1$, $P_2$, $P_3$, $P_4$) mit der Filterschaltung (3) verbunden wird und die zur Verbindung mit einem Stromnetz (7) vorgesehenen Leiter ($P_1$, $P_2$, $P_3$, $P_4$) des Wechselrichters (1) mit dem Netzrelais (4) verbunden werden, wobei die Filterschaltung (3) aus zumindest einer, in einem Leiter ($P_1$, $P_2$, $P_3$, $P_4$) angeordneten Filterinduktivität (LF) und zumindest einer Filterkapazität (CF), die zwei Leiter ($P_1$, $P_2$, $P_3$, $P_4$) miteinander verbindet, gebildet wird und für die Filterschaltung (3) eine Ersatzschaltung (15) aus einer wirksamen Filterinduktivität ($L_m$), die sich aus der zumindest einen Filterinduktivität (LF) der Filterschaltung (3) und der Topologie der Filterschaltung (3) ergibt, und einer wirksamen Filterkapazität ($C_m$), die sich aus der zumindest einen Filterkapazität (CF) der Filterschaltung (3) und der Topologie der Filterschaltung (3) ergibt, verwendet wird, wobei die wirksame Filterinduktivität ($L_m$) und die wirksame Filterkapazität ($C_m$) als Streckenparameter verwendet werden und wobei das Verfahren die folgenden Schritte aufweist, welche bei geöffnetem Netzrelais (4) durchgeführt werden:

   - Aufbringen eines Spannungsimpulses zwischen einem ersten Leiterausgang ($W_1$, $W_2$, $W_3$, $W_4$) und einem zweiten Leiterausgang ($W_1$, $W_2$, $W_3$, $W_4$),
   - Verbinden dieses ersten Leiterausgangs ($W_1$, $W_2$, $W_3$, $W_4$) und dieses zweiten Leiterausgangs ($W_1$, $W_2$, $W_3$, $W_4$) über die Schaltanordnung (2) zur Herstellung eines geschlossenen Schwingkreises (8, 8', 8"), der ausgehend vom ersten Leiterausgang ($W_1$, $W_2$, $W_3$, $W_4$), den mit dem ersten Leiterausgang ($W_1$, $W_2$, $W_3$, $W_4$) verbundenen ersten Leiter ($P_1$, $P_2$, $P_3$, $P_4$) über die Filterschaltung (3) und den zweiten Leiter ($P_1$, $P_2$, $P_3$, $P_4$) zum mit dem zweiten Leiter ($P_1$, $P_2$, $P_3$, $P_4$) verbundenen zweiten Leiterausgang ($W_1$, $W_2$, $W_3$, $W_4$) verläuft,
   - Ermitteln eines Strom- und/oder Spannungsverlaufs (11, 12) im Schwingkreis (8, 8', 8"),
   - Auswerten des Strom- und/oder Spannungsverlaufs (11, 12) zur Ermittlung zumindest eines aktuellen Werts der wirksamen Filterinduktivität ($L_m$) und der wirksamen Filterkapazität ($C_m$) der Filterschaltung (3) als Streckenparameter der Filterschaltung (3)

und die Schaltanordnung (2) des Wechselrichters (1) bei geschlossenem Netzrelais (4) unter Berücksichtigung der ermittelten aktuellen Werte der wirksamen Filterinduktivität ($L_m$) und der wirksamen Filterkapazität ($C_m$) der Filterschaltung (3) geregelt wird.

2. Verfahren nach Anspruch 1, **dadurch gekennzeichnet, dass** die Verfahrensschritte des Aufbringens eines Spannungsimpulses, des Herstellens eines Schwingkreises (8, 8', 8") und des Ermittelns und Auswertens eines Strom- und/oder Spannungsverlaufs (11, 12) an mehreren unterschiedlichen Leiterpaaren wiederholt wird.

3. Verfahren nach Anspruch 1 oder 2, **dadurch gekennzeichnet, dass** bei einem Wechselrichter (1) mit einem für eine Rückführung von der Filteranordnung (3) zur Schaltanordnung (2) vorgesehenen Leiter ($P_4$) als erster Leiter ($P_1$, $P_2$, $P_3$, $P_4$) einer der anderen Leiter ($P_1$, $P_2$, $P_3$, $P_4$) des Wechselrichters (1) verwendet wird und als zweiter Leiter der für die Rückführung von der Filteranordnung (3) zur Schaltanordnung (2) vorgesehene Leiter ($P_4$) verwendet wird.

4. Verfahren nach Anspruch 1 oder 2, **dadurch gekennzeichnet, dass** bei einem Wechselrichter (1) ohne einem für eine Rückführung von der Filteranordnung (3) zur Schaltanordnung (2) vorgesehenen Leiter ($P_4$) als erster Leiter ($P_1$, $P_2$, $P_3$) einer der verfügbaren Leiter ($P_1$, $P_2$, $P_3$) des Wechselrichters (1) verwendet wird und als zweiter Leiter ein anderer der verfügbaren Leiter ($P_1$, $P_2$, $P_3$) des Wechselrichters (1).

5. Verfahren nach Anspruch 4, **dadurch gekennzeichnet, dass** ein für die Ermittlung der wirksamen Filterinduktivität ($L_m$) und Filterkapazität ($C_m$) ungenutzter Leiter ($P_1$, $P_2$, $P_3$, $P_4$) des Wechselrichters (1) über die Schaltanordnung (2) auf ein Zwischenkreispotential (DC+, DC-) gelegt wird.

6. Verfahren nach einem der Ansprüche 1 bis 5, **dadurch gekennzeichnet, dass** aus dem Strom- und Spannungsverlauf (11, 12) eine Resonanzfrequenz ($f_{reso}$) des Schwingkreises (8, 8', 8") ermittelt wird, wobei ein Wert der wirksamen Filterinduktivität ($L_m$) gemäß der Formel

$$L_m = \frac{1}{2 \cdot \pi \cdot f_{reso}} \cdot \frac{U}{I}$$

ermittelt wird.

7. Verfahren nach einem der Ansprüche 1 bis 5, **dadurch gekennzeichnet, dass** aus dem Strom- und Spannungsverlauf (11, 12) eine Resonanzfrequenz ($f_{reso}$) des Schwingkreises (8, 8', 8") ermittelt wird, wobei ein Wert der wirksamen Filterkapazität gemäß der Formel

$$C_m = \frac{1}{2 \cdot \pi \cdot f_{reso}} \cdot \frac{I}{U}$$

ermittelt wird.

8. Verfahren nach einem der Ansprüche 1 bis 7, **dadurch gekennzeichnet, dass** ein Abklingverhalten des Strom- und/oder Spannungsverlaufs (11, 12) im Schwingkreis (8, 8', 8") ermittelt wird und das Abklingverhalten in der Regelung berücksichtigt wird.

9. Verfahren nach einem der Ansprüche 1 bis 8, **dadurch gekennzeichnet, dass** die Herstellung eines geschlossenen Schwingkreises (8, 8', 8") unmittelbar nach dem Spannungsimpuls erfolgt.

10. Wechselrichter umfassend eine Schaltanordnung (2) mit Halbleiterschaltern (T) und eine Systemsteuerung (6), in der eine Regelung (16) mit einem Regler (R) mit Reglerparameter (RP) zum Regeln des Schaltens der Halbleiterschalter (T) implementiert ist, wobei der Wechselrichter (1) zusätzlich eine Filterschaltung (3) und ein Netzrelais (4) umfasst und die Regelung (16) ausgestaltet ist, Streckenparameter der Filterschaltung (3) des Wechselrichters (1) zu berücksichtigen, wobei an der Schaltanordnung (2) zumindest zwei Leiterausgängen ($W_1$, $W_2$, $W_3$, $W_4$) vorgesehen sind und jeder Leiterausgang ($W_1$, $W_2$, $W_3$, $W_4$) über einen Leiter ($P_1$, $P_2$, $P_3$, $P_4$) mit der Filterschaltung (3) verbunden ist und die zur Verbindung mit einem Stromnetz (7) vorgesehenen Leiter ($P_1$, $P_2$, $P_3$, $P_4$) des Wechselrichters (1) mit dem Netzrelais (4) verbunden sind, wobei in der Filterschaltung (3) zumindest eine, in einem Leiter

($P_1$, $P_2$, $P_3$, $P_4$) angeordneten Filterinduktivität (LF) und zumindest eine Filterkapazität (CF), die zwei Leiter ($P_1$, $P_2$, $P_3$, $P_4$) miteinander verbindet, vorgesehen ist, **dadurch gekennzeichnet, dass** als Streckenparameter eine wirksame Filterinduktivität ($L_m$), die sich aus der zumindest einen Filterinduktivität (LF) der Filterschaltung (3) und der Topologie der Filterschaltung (3) ergibt, und eine wirksame Filterkapazität ($C_m$), die sich aus der zumindest einen Filterkapazität (CF) der Filterschaltung (3) und der Topologie der Filterschaltung (3) ergibt, einer Ersatzschaltung (15) der Filterschaltung (3) vorgesehen sind, **dass** die Schaltanordnung (2) ausgestaltet ist, bei geöffnetem Netzrelais (4) einen Spannungsimpulses zwischen einem ersten Leiterausgang ($W_1$, $W_2$, $W_3$, $W_4$) und einem zweiten Leiterausgang ($W_1$, $W_2$, $W_3$, $W_4$) aufzubringen, **dass** die Schaltanordnung (2) ausgestaltet ist, nach dem Aufbringen des Spannungsimpulses diesen ersten Leiterausgang ($W_1$, $W_2$, $W_3$, $W_4$) und diesen zweiten Leiterausgang ($W_1$, $W_2$, $W_3$, $W_4$) zur Herstellung eines geschlossenen Schwingkreises (8, 8', 8") , der ausgehend vom ersten Leiterausgang ($W_1$, $W_2$, $W_3$, $W_4$), dem damit verbundenen ersten Leiter ($P_1$, $P_2$, $P_3$, $P_4$) über die Filterschaltung (3), den zweiten Leiter ($P_1$, $P_2$, $P_3$, $P_4$) zum damit verbundenen zweiten Leiterausgang ($W_1$, $W_2$, $W_3$, $W_4$) verläuft, zu verbinden, **dass** die Systemsteuerung (6) ausgestaltet ist, aus einem im Schwingkreis (8, 8', 8") ermittelten elektrischen Strom und/oder einer im Schwingkreis (8, 8', 8") ermittelten elektrischen Spannung einen aktuellen Wert der wirksamen Filterinduktivität ($L_m$) und der wirksamen Filterkapazität ($C_m$) der Filterschaltung (3) zu ermitteln, **und dass** die Systemsteuerung (6) ausgestaltet ist, den Wechselrichter (1) bei geschlossenem Netzrelais (4) mit den ermittelten aktuellen Werten der wirksamen Filterinduktivität ($L_m$) und der wirksamen Filterkapazität ($C_m$) der Filterschaltung (3) zu regeln.

**11.** Computerprogramm mit Programmcode zur Durchführung aller Verfahrensschritte gemäß einem der Ansprüche 1 bis 9, wenn das Computerprogramm auf einer Systemsteuerung (6) eines Wechselrichters (1) ausgeführt wird.

**Claims**

**1.** A method for controlling a switching arrangement (2) of an inverter (1) with a control (16), wherein the inverter (1) has the switching arrangement (2), a filter circuit (3) and a grid relay (4) and the control (16) takes system parameters of the filter circuit (3) of the inverter (1) into account, wherein the switching arrangement (2) has at least two conductor outputs ($W_1$, $W_2$, $W_3$, $W_4$) and each conductor output ($W_1$, $W_2$, $W_3$, $W_4$) is connected to the filter circuit (3) by a conductor ($P_1$, $P_2$, $P_3$, $P_4$), and the conductors ($P_1$, $P_2$, $P_3$, $P_4$) of the inverter (1) provided for connection to a power grid (7) are connected to the grid relay (4), wherein the filter circuit (3) is formed from at least one filter inductance (LF) arranged in a conductor ($P_1$, $P_2$, $P_3$, $P_4$) and at least one filter capacitance (CF) which connects two conductors ($P_1$, $P_2$, $P_3$, $P_4$) to one another, and for the filter circuit (3) use is made of an equivalent circuit (15) consisting of an effective filter inductance ($L_m$), which results from the at least one filter inductance (LF) of the filter circuit (3) and the topology of the filter circuit (3), and an effective filter capacitance ($C_m$), which results from the at least one filter capacitance (CF) of the filter circuit (3) and the topology of the filter circuit (3), wherein the effective filter inductance ($L_m$) and the effective filter capacitance ($C_m$) are used as system parameters, and the method comprises the following steps which are carried out with the grid relay (4) open:

- applying a voltage pulse between a first conductor output ($W_1$, $W_2$, $W_3$, $W_4$) and a second conductor output ($W_1$, $W_2$, $W_3$, $W_4$),
- connecting this first conductor output ($W_1$, $W_2$, $W_3$, $W_4$) and this second conductor output ($W_1$, $W_2$, $W_3$, $W_4$) via the switching arrangement (2) to produce a closed oscillating circuit (8, 8', 8") which runs, starting from the first conductor output ($W_1$, $W_2$, $W_3$, $W_4$) and the first conductor ($P_1$, $P_2$, $P_3$, $P_4$) connected to the first conductor output ($W_1$, $W_2$, $W_3$, $W_4$) via the filter circuit (3) and the second conductor ($P_1$, $P_2$, $P_3$, $P_4$) to the second conductor output ($W_1$, $W_2$, $W_3$, $W_4$) connected to the second conductor ($P_1$, $P_2$, $P_3$, $P_4$),
- determining a current curve and/or voltage curve (11, 12) in the oscillating circuit (8, 8', 8"),
- evaluating the current curve and/or voltage curve (11, 12) to determine at least one current value of the effective filter inductance ($L_m$) and the effective filter capacitance ($C_m$) of the filter circuit (3) as system parameters of the filter circuit (3)

and the switching arrangement (2) of the inverter (1) is controlled with closed grid relay (4) taking into account the determined current values of the effective filter inductance ($L_m$) and the effective filter capacitance ($C_m$) of the filter circuit (3).

**2.** The method according to claim 1, **characterized in that** the method steps of applying a voltage pulse, producing an oscillating circuit (8, 8', 8") and determining and evaluating a current and/or voltage curve (11, 12) are repeated on a plurality of different pairs of conductors.

3. The method according to claim 1 or 2, **characterized in that** in an inverter (1) with a conductor ($P_4$) provided for a feedback from the filter arrangement (3) to the switching arrangement (2), one of the other conductors ($P_1$, $P_2$, $P_3$, $P_4$) of the inverter (1) is used as the first conductor ($P_1$, $P_2$, $P_3$, $P_4$), and the conductor ($P_4$) provided for the feedback from the filter arrangement (3) to the switching arrangement (2) is used as the second conductor.

4. The method according to claim 1 or 2, **characterized in that** in the case of an inverter (1) without a conductor ($P_4$) provided for a feedback from the filter arrangement (3) to the switching arrangement (2), one of the available conductors ($P_1$, $P_2$, $P_3$) of the inverter (1) is used as the first conductor ($P_1$, $P_2$, $P_3$), and another of the available conductors ($P_1$, $P_2$, $P_3$) of the inverter (1) is used as the second conductor.

5. The method according to claim 4, **characterized in that** a conductor ($P_1$, $P_2$, $P_3$, $P_4$) of the inverter (1) that is not used for determining the effective filter inductance ($L_m$) and filter capacitance ($C_m$) is connected to an intermediate circuit potential (DC+, DC-) via the switching arrangement (2).

6. The method according to any of claims 1 to 5, **characterized in that** a resonant frequency ($f_{reso}$) of the oscillating circuit (8, 8', 8") is determined from the current curve and voltage curve (11, 12), wherein according to the formula

$$L_m = \frac{1}{2 \cdot \pi \cdot f_{reso}} \cdot \frac{U}{I}$$

a value of the effective filter inductance ($L_m$) is determined.

7. The method according to any of claims 1 to 5, **characterized in that** a resonant frequency ($f_{reso}$) of the oscillating circuit (8, 8', 8") is determined from the current and voltage curve (11, 12), wherein according to the formula

$$C_m = \frac{1}{2 \cdot \pi \cdot f_{reso}} \cdot \frac{I}{U}$$

a value of the effective filter capacitance ($C_m$) is determined.

8. The method according to any of claims 1 to 7, **characterized in that** a decay behavior of the current curve and/or voltage curve (11, 12) in the oscillating circuit (8, 8', 8") is determined and the decay behavior is taken into account in the control.

9. The method according to any of claims 1 to 8, **characterized in that** a closed oscillating circuit (8, 8', 8") is produced immediately after the voltage pulse.

10. An inverter comprising a switching arrangement (2) with semiconductor switches (T) and a system control (6), in which a control (16) with a controller (R) with controller parameters (RP) for controlling the switching of the semiconductor switches (T) is implemented, wherein the inverter (1) further comprises a filter circuit (3) and a grid relay (4) and the control (16) is configured to take system parameters of the filter circuit (3) of the inverter (1) into account, wherein at least two conductor outputs ($W_1$, $W_2$, $W_3$, $W_4$) are provided on the switching arrangement (2) and each conductor output ($W_1$, $W_2$, $W_3$, $W_4$) is connected to the filter circuit (3) via a conductor ($P_1$, $P_2$, $P_3$, $P_4$), and the conductors ($P_1$, $P_2$, $P_3$, $P_4$) of the inverter (1) provided for connection to a power grid (7) are connected to the grid relay (4), wherein at least one filter inductance (LF) arranged in a conductor ($P_1$, $P_2$, $P_3$, $P_4$) and at least one filter capacitance (CF) which connects two conductors ($P_1$, $P_2$, $P_3$, $P_4$) to one another are provided in the filter circuit (3), **characterized in that** an effective filter inductance ($L_m$), which results from the at least one filter inductance (LF) of the filter circuit (3) and the topology of the filter circuit (3), and an effective filter capacitance ($C_m$), which results from the at least one filter capacitance (CF) of the filter circuit (3) and the topology of the filter circuit (3), of an equivalent circuit (15) of the filter circuit (3) are provided as system parameter, **in that** the switching arrangement (2) is configured to apply a voltage pulse between a first conductor output ($W_1$, $W_2$, $W_3$, $W_4$) and a second conductor output ($W_1$, $W_2$, $W_3$, $W_4$) when the grid relay (4) is open, **in that** the switching arrangement (2) is configured to connect this first conductor output ($W_1$, $W_2$, $W_3$, $W_4$) and this second conductor output ($W_1$, $W_2$, $W_3$, $W_4$) after the application of the voltage pulse to produce a closed oscillating circuit (8, 8', 8") which runs, starting from the first

conductor output ($W_1$, $W_2$, $W_3$, $W_4$) and the first conductor connected thereto ($P_1$, $P_2$, $P_3$, $P_4$) via the filter circuit (3) and the second conductor ($P_1$, $P_2$, $P_3$, $P_4$) to the second conductor output ($W_1$, $W_2$, $W_3$, $W_4$) connected thereto, **in that** the system control (6) is configured to determine a current value of the effective filter inductance ($L_m$) and the effective filter capacitance ($C_m$) of the filter circuit (3) from an electrical current determined in the oscillating circuit (8, 8', 8") and/or from an electrical voltage determined in the oscillating circuit (8, 8', 8"), **and in that** the system control (6) is configured to control the inverter (1) with closed grid relay (4) with the determined current values of the effective filter inductance ($L_m$) and the effective filter capacitance ($C_m$) of the filter circuit (3).

**11.** A computer program with program code for carrying out all method steps according to any of claims 1 to 9, when the computer program is executed on a system control (6) of an inverter (1).

**Revendications**

**1.** Procédé de régulation d'un agencement de circuit (2) d'un onduleur (1) avec une régulation (16), dans lequel l'onduleur (1) présente l'agencement de circuit (2), un circuit de filtre (3) et un relais de réseau (4) et la régulation (16) tient compte de paramètres de courbe du circuit de filtre (3) de l'onduleur (1), dans lequel l'agencement de circuit (2) présente au moins deux sorties de conducteur ($W_1$, $W_2$, $W_3$, $W_4$) et chaque sortie de conducteur ($W_1$, $W_2$, $W_3$, $W_4$) est raccordée à un conducteur ($P_1$, $P_2$, $P_3$, $P_4$) avec le circuit de filtre (3) et les conducteurs ($P_1$, $P_2$, $P_3$, $P_4$) de l'onduleur (1) prévus pour un raccordement à un réseau électrique (7) sont raccordés au relais de réseau (4), dans lequel le circuit de filtre (3) est formé d'au moins une inductance de filtre (LF) agencée dans un conducteur ($P_1$, $P_2$, $P_3$, $P_4$) et d'au moins une capacité de filtre (CF), qui raccorde deux conducteurs ($P_1$, $P_2$, $P_3$, $P_4$) l'un à l'autre et, pour le circuit de filtre (3), un circuit équivalent (15) est utilisé, constitué d'une inductance de filtre effective ($L_m$), qui résulte de l'au moins une inductance de filtre (LF) du circuit de filtre (3) et de la topologie du circuit de filtre (3), et d'une capacité de filtre effective ($C_m$), qui résulte de l'au moins une capacité de filtre (CF) du circuit de filtre (3) et de la topologie du circuit de filtre (3), dans lequel l'inductance de filtre effective ($L_m$) et la capacité de filtre effective ($C_m$) sont utilisés comme paramètres de courbe et dans lequel le procédé présente les étapes suivantes, qui sont réalisées lorsque le relais de réseau (4) est ouvert :

- application d'une impulsion de tension entre une première sortie de conducteur ($W_1$, $W_2$, $W_3$, $W_4$) et une deuxième sortie de conducteur ($W_1$, $W_2$, $W_3$, W4),
- raccordement de cette première sortie de conducteur ($W_1$, $W_2$, $W_3$, $W_4$) et de cette deuxième sortie de conducteur ($W_1$, $W_2$, $W_3$, $W_4$) par le biais de l'agencement de circuit (2) pour la production d'un circuit résonant fermé (8, 8', 8"), qui s'étend de la première sortie de conducteur ($W_1$, $W_2$, $W_3$, $W_4$), du premier conducteur ($P_1$, $P_2$, $P_3$, $P_4$) raccordé à la première sortie de conducteur ($W_1$, $W_2$, $W_3$, $W_4$) par le biais du circuit de filtre (3) et du deuxième conducteur ($P_1$, $P_2$, $P_3$, $P_4$) jusqu'à la deuxième sortie de conducteur ($W_1$, $W_2$, $W_3$, $W_4$) raccordée au deuxième conducteur ($P_1$, $P_2$, $P_3$, $P_4$),
- détermination d'une courbe de courant et/ou de tension (11, 12) dans le circuit résonant (8, 8', 8"),
- analyse de la courbe de courant et/ou tension (11, 12) pour déterminer au moins une valeur réelle de l'inductance de filtre effective ($L_m$) et de la capacité de filtre effective ($C_m$) du circuit de filtre (3) en tant que paramètres de courbe du circuit de filtre (3)

et l'agencement de circuit (2) de l'onduleur (1) lorsque le relais de réseau (4) est fermé, est régulé en tenant compte de la valeur réelle déterminée de l'inductance de filtre effective ($L_m$) et de la capacité de filtre effective ($C_m$) du circuit de filtre (3).

**2.** Procédé selon la revendication 1, **caractérisé en ce que** les étapes de procédé d'application d'une impulsion de tension, de production d'un circuit résonant (8, 8', 8") et de détermination et d'analyse d'une courbe de courant et/ou tension (11, 12) sont répétées au niveau de plusieurs paires de conducteurs différentes.

**3.** Procédé selon la revendication 1 ou 2, **caractérisé en ce que** pour un onduleur (1) avec un conducteur ($P_4$) prévu pour une rétroaction de l'agencement de filtre (3) à l'agencement de circuit (2), l'un des autres conducteurs ($P_1$, $P_2$, $P_3$, $P_4$) de l'onduleur (1) est utilisé en tant que premier conducteur ($P_1$, $P_2$, $P_3$, $P_4$ ) et en tant que deuxième conducteur, le conducteur ($P_4$) prévu pour la rétroaction de l'agencement de filtre (3) à l'agencement de circuit (2), est utilisé.

**4.** Procédé selon la revendication 1 ou 2, **caractérisé en ce que** pour un onduleur (1) sans un conducteur ($P_4$) prévu pour une rétroaction de l'agencement de filtre (3) à l'agencement de circuit (2), l'un des conducteurs disponibles

($P_1$, $P_2$, $P_3$) de l'onduleur (1) est utilisé comme premier conducteur ($P_1$, $P_2$, $P_3$) et en tant que deuxième conducteur, un autre des conducteurs disponibles ($P_1$, $P_2$, $P_3$) de l'onduleur (1) est utilisé.

5. Procédé selon la revendication 4, **caractérisé en ce qu'**un conducteur ($P_1$, $P_2$, $P_3$, $P_4$ ) de l'onduleur (1) inutilisé pour la détermination de l'inductance de filtre effective ($L_m$) et la capacité de filtre effective ($C_m$) est positionné par le biais de l'agencement de circuit (2) sur un potentiel de circuit intermédiaire (DC+, DC-).

6. Procédé selon l'une quelconque des revendications 1 à 5,
**caractérisé en ce que,** à partir de la courbe de courant et de tension (11, 12), une fréquence de résonance ($f_{reso}$) du circuit résonant (8, 8', 8") est déterminée, dans lequel une valeur de l'inductance de filtre effective ($L_m$) est déterminée selon la formule

$$L_m = \frac{1}{2 \cdot \pi \cdot f_{reso}} \cdot \frac{U}{I}.$$

7. Procédé selon l'une quelconque des revendications 1 à 5,
**caractérisé en ce que,** à partir de la courbe de courant et de tension (11, 12), une fréquence de résonance ($f_{reso}$) du circuit résonant (8, 8', 8") est déterminée, dans lequel une valeur de la capacité de filtre effective est déterminée selon la formule

$$C_m = \frac{1}{2 \cdot \pi \cdot f_{reso}} \cdot \frac{I}{U}.$$

8. Procédé selon l'une quelconque des revendications 1 à 7,
**caractérisé en ce qu'**un comportement à la baisse de la courbe de courant et/ou de tension (11, 12) dans le circuit résonant (8, 8', 8") est déterminé et le comportement à la baisse est pris en compte dans la régulation.

9. Procédé selon l'une quelconque des revendications 1 à 8,
**caractérisé en ce que** la production d'un circuit résonant fermé (8, 8', 8") s'effectue directement après l'impulsion de tension.

10. Onduleur comprenant un agencement de circuit (2) avec des commutateurs à semi-conducteurs (T) et une régulation de système (6), dans laquelle une régulation (16) est implémentée avec un régulateur (R) avec des paramètres de régulation (RP) pour la régulation de la commutation des commutateurs à semi-conducteurs (T), dans lequel l'onduleur (1) comprend en outre un circuit de filtre (3) et un relais de réseau (4) et la régulation (16) est conçue pour prendre en compte des paramètres de courbe du circuit de filtre (3) de l'onduleur (1), dans lequel, au niveau de l'agencement de circuit (2), au moins deux sorties de conducteur ($W_1$, $W_2$, $W_3$, $W_4$) sont prévues et chaque sortie de conducteur ($W_1$, $W_2$, $W_3$, $W_4$ ) est raccordée par le biais d'un conducteur ($P_1$, $P_2$, $P_3$, $P_4$ ) au circuit de filtre (3) et les conducteurs ($P_1$, $P_2$, $P_3$, $P_4$ ) de l'onduleur (1) prévus pour le raccordement avec un réseau électrique (7) sont raccordés au relais de réseau (4), dans lequel dans le circuit de filtre (3), au moins une inductance de filtre (LF) agencée dans un conducteur ($P_1$, $P_2$, $P_3$, $P_4$ ) et au moins une capacité de filtre (CF), qui raccorde deux conducteurs ($P_1$, $P_2$, $P_3$, $P_4$ ) l'un à l'autre, sont prévues, **caractérisé en ce qu'**en guise de paramètres de courbe, une inductance de filtre effective ($L_m$), qui résulte de l'au moins une inductance de filtre (LF) du circuit de filtre (3) et de la topologie du circuit de filtre (3), et une capacité de filtre effective ($C_m$), qui résulte de l'au moins une capacité de filtre (CF) du circuit de filtre (3) et de la topologie du circuit de filtre (3), d'un circuit équivalent (15) du circuit de filtre (3) sont prévues, **que** l'agencement de circuit (2) est conçu pour appliquer, lorsque le relais de réseau (4) est ouvert, une impulsion de tension entre une première sortie de conducteur ($W_1$, $W_2$, $W_3$, $W_4$) et une deuxième sortie de conducteur ($W_1$, $W_2$, $W_3$, $W_4$), **que** l'agencement de circuit (2) est conçu, après l'application de l'impulsion de tension, pour raccorder cette première sortie de conducteur ($W_1$, $W_2$, $W_3$, $W_4$ ) et cette deuxième sortie de conducteur ($W_1$, $W_2$, $W_3$, $W_4$) pour la production d'un circuit résonant fermé (8, 8', 8"), qui s'étend à partir de la première sortie de conducteur ($W_1$, $W_2$, $W_3$, $W_4$), du premier conducteur ($P_1$, $P_2$, $P_3$, $P_4$) raccordé à celle-ci, par le biais du circuit de filtre (3), du deuxième conducteur ($P_1$, $P_2$, $P_3$, $P_4$) jusqu'à la deuxième sortie de conducteur ($W_1$, $W_2$, $W_3$, $W_4$) raccordée à celui-ci, **que** la régulation de système (6) est conçue pour déterminer, à partir d'un courant électrique déterminé dans le circuit résonant (8, 8', 8") et/ou d'une tension électrique déterminée dans le circuit résonant (8, 8', 8"), une valeur réelle de l'inductance de filtre effective ($L_m$) et de la capacité de filtre effective ($C_m$) du circuit de filtre (3) **et que** la commande de système (6) est conçue pour réguler l'onduleur (1) lorsque le relais de réseau (4) est fermé avec les valeurs réelles déterminées de l'inductance de filtre effective ($L_m$) et de la capacité de filtre effective ($C_m$) du circuit de filtre (3).

11. Programme informatique comprenant un code de programme pour la réalisation de toutes les étapes de procédé selon l'une quelconque des revendications 1 à 9, lorsque le programme informatique est exécuté sur une commande de système (6) d'un onduleur (1).

Fig. 1

Fig. 2

Fig. 3

Fig. 4

Fig. 5

Fig. 6

Fig. 7

Fig. 8

Fig. 9

EP 4 046 268 B1

# Fig. 10

# Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3232217 A1

- EP 3069158 B1